# EUROPÄISCHE PATENTSCHRIFT

(11) **EP 3 425 414 B1**
(45) Veröffentlichungstag und Bekanntmachung des Hinweises auf die Patenterteilung: **24.11.2021**
(21) Anmeldenummer: 18181401.3
(22) Anmeldetag: 03.07.2018
(51) Int. Cl.: G01R 33/36, G01R 33/34, H01G 4/38, H01G 5/38

(54) **ANPASSUNGSEINRICHTUNG FÜR EINEN HF-RESONANZKREIS EINES NMR-PROBENKOPFS**
ADJUSTMENT DEVICE FOR A HF RESONANCE CIRCUIT OF A NMR SAMPLE HEAD
DISPOSITIF DE RÉGLAGE POUR UN CIRCUIT RÉSONANT HF D'UNE TÊTE D'ÉCHANTILLON NMR

(30) Priorität: 04.07.2017 DE 102017211401
(43) Veröffentlichungstag der Anmeldung: 09.01.2019
(73) Patentinhaber: Bruker Switzerland AG, 8117 Fällanden (CH)
(72) Erfinder: Meister, Roger, 8132 Hinteregg (CH); Baumann, Daniel Guy, 8117 Fällanden (CH); Schmidig, Daniel, 8200 Schaffhausen (CH); Kasper, Christian, 8117 Fällanden (CH)
(74) Vertreter: Kohler Schmid Möbus Patentanwälte

(56) Entgegenhaltungen:
- DE-A1-102006 030 640
- JP-A- 2008 020 397
- US-A- 1 350 279
- US-A- 1 594 700
- US-A- 5 986 455

## Beschreibung

Die Erfindung betrifft eine Anpassungseinrichtung für einen HF-Resonanzkreis eines NMR-Probenkopfs.

Ein NMR-Probenkopf mit verstellbarer Frequenz ist aus der EP 0 930 511 B1 bekannt.

Kernspinresonanz(=NMR, nuclear magnetic resonance)-Spektroskopie ist ein leistungsfähiges Verfahren der instrumentellen Analytik, mit dem die chemische Zusammensetzung von Messsubstanzen (Proben) untersucht werden kann. Dabei wird die Messsubstanz einem starken, statischen Magnetfeld ausgesetzt, wodurch es zur Ausrichtung von Kernspins in der Messsubstanz kommt. Nach Einstrahlung von HF(=Hochfrequenz)-Pulsen werden von der Messsubstanz ausgehende HF-Signale aufgenommen und zur Bestimmung der chemischen Zusammensetzung ausgewertet.

Das starke, statische magnetische Feld wird oftmals mittels supraleitender Magnete erzeugt, welche in einem Kryostaten gekühlt werden. Die zu untersuchende Probe wird in einer Raumtemperaturbohrung des Kryostaten angeordnet. Die Einstrahlung der HF-Pulse bzw. die Aufnahme von HF-Signalen erfolgt über eine oder mehrere HF-Resonatorspulen eines Probenkopfs, der in die Raumtemperaturbohrung ragt. Typischerweise wird durch den Probenkopf auch die zu vermessende Probe gehalten.

Durch die Anordnung in der Raumtemperaturbohrung des Kryostaten ist der Bauraum für den Probenkopf recht beengt. Insbesondere muss der Probenkopf meist eine im Wesentlichen zylindrische Bauform einhalten.

Die Frequenz der von einer HF-Resonatorspule ausgesandten HF-Pulse bzw. aufgenommenen HF-Signale hängt von der Art der untersuchten Atomkerne und der Stärke des statischen Magnetfelds ab. Die HF-Resonatorspule ist Teil eines HF-Resonanzkreises (Stromkreises), dessen Resonanzfrequenz sich aus den enthaltenen Bauelementen (insbesondere deren Kapazität und Induktivität) und deren Verschaltung ergibt. Die Resonanzfrequenz muss auf die Art der untersuchten Atomkerne und die Stärke des statischen Magnetfelds abgestimmt sein.

Für NMR-Experimente mit verschiedenen Atomkernsorten und/oder unterschiedlichen Magnetfeldstärken können unterschiedliche Probenköpfe vorgehalten werden; dies ist jedoch sehr teuer und verursacht erheblichen Umbauaufwand.

Die Druckschrift EP 0 930 511 B1 diskutiert Probenköpfe, die auf verschiedene Frequenzen eingestellt werden können. Allerdings ist aufgrund der beengten Platzverhältnisse die Zahl der Bauelemente und deren Verstellmechanismen begrenzt. Es wird ein NMR-Probenkopf vorgeschlagen, umfassend einen Kondensator mit verstellbarer Kapazität, wobei für einen kompakten Bau ein inneres Kondensatorelement gegenüber einem äußeren Kondensatorelement über eine Verschraubung beweglich ist. Bei dieser nach Art eines Zylinderkondensators ausgebildeten Bauform kann die Kapazität stufenlos, aber lediglich in einem kleinen Kapazitätsbereich verstellt werden.

Aus der DE 198 33 350 C1 ist ein Probenkopf bekannt geworden, bei dem eine Messspule an unterschiedliche Eingangsklemmen zur Einspeisung niederfrequenter Isotope (X) und dem 1H-Kern mit höherer Frequenz angeschlossen ist. Die Entkopplung der 1H Frequenz erfolgt über einen Serienkondensator und eine Lambda/4 Leitung, die mit einem Kapazitätsbelag behaftet ist, der über einen Kurzschlussschieber über die Länge der Leitung einstellbar ist. Auch hier ist der Verstellbereich recht klein.

Eine auf ähnliche Weise einstellbare Lambda/4-Leitung für einen NMR-Probenkopf ist auch aus der EP 1 651 973 B1 bekannt.

Aus der DE 10 2006 030 640 A1 und der JP 2008 020397 A sind NMR-Sonden bekannt geworden, bei denen Abstimmelemente mittels einer Drehscheibe umgeschaltet werden können.

In Breitband-Probenköpfen der Bruker BioSpin AG, Fällanden, CH, wurden mehrere Schieberegister im Probenkopf verbaut. Mit jedem Schieberegister kann ein Kondensator ausgewählt werden; die ausgewählten Kondensatoren der verschiedenen Schieberegister sind parallel geschaltet. Durch geeignete Einstellung der Schieberegister bzw. Auswahl der Kondensatoren kann die Resonanzfrequenz einer HF-Resonatorspule eingestellt werden. Diese Bauweise ist jedoch teuer, insbesondere aufgrund der für jedes Schieberegister benötigten Aktuatoren, und erfordert viel Bauraum, was die Performance des Probenkopfs begrenzt.

Aus der US 1,594,700 ist ein Kondensator mit variabler Kapazität für die Telefonie bekannt geworden. Dabei können um eine Achse drehbare Flügel gegenüber ortsfesten Flügeln aus- und eingedreht werden.

Die US 1,350,279 beschreibt einen variablen Kondensator mit fünf unterschiedlich verzahnten, gemeinsam verdrehbaren Scheiben, die je nach Drehstellung und entsprechend ihrer Verzahnung jeweils gegenüberliegende Bürsten kontaktieren oder nicht kontaktieren. Die Bürsten sind mit Kondensatoren unterschiedlicher Kapazität seriell verbunden.

### Aufgabe der Erfindung

Der Erfindung liegt die Aufgabe zugrunde, eine Anpassungseinrichtung für einen HF-Resonanzkreis eines NMR-Probenkopfs zur Verfügung zu stellen, die bei kompaktem Bau und einfachem Betätigungsmechanismus einen großen Verstellbereich von Resonanzfrequenzen ermöglicht.

### Kurze Beschreibung der Erfindung

Diese Aufgabe wird gelöst durch eine Anpassungseinrichtung für einen HF-Resonanzkreis eines NMR-Probenkopfs, die dadurch gekennzeichnet ist,
dass die Anpassungseinrichtung eine Vielzahl von beweglichen Elementen umfasst, welche aufeinanderfolgend angeordnet sind, wobei jeweils benachbarte bewegliche Elemente ineinander greifen, so dass diese in einem begrenzten Bereich gegeneinander beweglich sind,
dass die beweglichen Elemente jeweils wenigstens ein elektrisches Funktionsteil zur Anpassung des HF-Resonanzkreises und N nach außen gerichtete elektrische Kontaktelemente, mit N eine natürliche Zahl ≥ 1, umfassen, wobei jedes elektrische Funktionsteil wenigstens zwei Funktionsteil-Anschlusspole aufweist, und wobei die elektrischen Kontaktelemente jeweils mit einem Funktionsteil-Anschlusspol verbunden sind,
dass die Anpassungseinrichtung weiterhin eine erste Anschlussanordnung zum Abfahren zumindest eines Teils der beweglichen Elemente von außen aufweist, um die Kontaktelemente der beweglichen Elemente abhängig von der Bewegungsstellung der beweglichen Elemente zu kontaktieren, wobei über die
erste Anschlussanordnung das jeweilige wenigstens eine elektrische Funktionsteil der Vielzahl von beweglichen Elementen elektrisch kontaktiert werden kann,
und dass die Anpassungseinrichtung weiterhin eine Bewegungseinrichtung umfasst, mit der ein bewegliches Element der beweglichen Elemente bewegt werden kann.

Im Rahmen der vorliegenden Erfindung kann eine Vielzahl von beweglichen Elementen für die Anpassung eines HF-Resonanzkreises (Stromkreises) eingesetzt werden. Jedes bewegliche Element umfasst wenigstens ein elektrisches Funktionsteil, das über die erste Anschlussanordnung elektrisch kontaktiert werden kann und dadurch in den HF-Resonanzkreis einbezogen werden kann, insbesondere zur Einstellung einer Resonanzfrequenz (oder eines Resonanzfrequenz-Intervalls) des HF-Resonanzkreises. Typische elektrische Funktionsteile sind Kondensatoren und Spulen oder Verschaltungen dieser Bauelemente; ein Funktionsteil kann aber beispielsweise auch als Kurzschlussbrücke ausgebildet sein.

Die beweglichen Elemente umfassen typischerweise jeweils nur ein elektrisches Funktionsteil, das je nach Bewegungsstellung in den HF-Resonanzkreis hineingenommen (aufgeschaltet) oder aus diesem herausgenommen (abgeschaltet) werden kann. Alternativ kann ein bewegliches Element auch mehrere elektrische Funktionsteile umfassen, zwischen denen im HF-Resonanzkreis je nach Bewegungsstellung umgeschaltet werden kann, wobei bevorzugt auch in zumindest einer Bewegungsstellung eines bewegliche Elements alle elektrischen Funktionsteile dieses beweglichen Elements aus dem Stromkreis herausgenommen werden können.

Durch die über die beweglichen Elemente schaltbaren elektrischen Funktionsteile kann der HF-Resonanzkreis bzw. der zugehörige Probenkopf auf verschiedene Atomkernarten (etwa 1H, 13C, 15N und/oder 109Ag) und verschiedene B₀-Felder angepasst werden. Dabei können vergleichsweise große und gut voneinander zu isolierende elektrische Funktionsteile verbaut werden, über die auch hohe Leistungen gehandhabt werden können (anders als zum Beispiel in einem integrierten Schaltkreis).

Die Bewegungsstellung der beweglichen Elemente kann mittels der Bewegungseinrichtung eingestellt werden. Die Bewegungseinrichtung umfasst bevorzugt einen mit einer elektronischen Steuerung automatisch betätigten Elektromotor. Da die beweglichen Elemente aufeinanderfolgend ineinandergreifen und gegeneinander nur begrenzt beweglich sind, kann durch Verdrehen eines der beweglichen Elemente auch ein Verdrehen der übrigen beweglichen Elemente in gewünschte Positionen erfolgen: Wird ein bewegliches Element gedreht, so wird ein benachbartes bewegliches Element mitgenommen, sobald ein Rand (Anschlag) des begrenzten gegenseitige Verdrehbereichs erreicht ist.

Durch geeignete Drehwinkel und Umkehrungen der Bewegungsrichtung an der Bewegungseinrichtung können praktisch beliebige Bewegungsstellungen der einzelnen beweglichen Elemente eingestellt werden. Die Bewegungseinrichtung greift typischerweise nur an einem beweglichen Element an (meist das vorderste in der Abfolge).

Im Rahmen der Erfindung genügt eine einzige Bewegungseinrichtung, um eine praktisch unbegrenzte Zahl von beweglichen Elementen zu verstellen und damit die elektrischen Eigenschaften des HF-Resonanzkreises (Stromkreises) einzustellen. Die beweglichen Elemente müssen lediglich aufeinanderfolgend ineinandergreifen, was in einer linearen Abfolge der beweglichen Elemente, insbesondere entlang einer Erstreckungsrichtung eines NMR-Probenkopfes bzw. einer Raumtemperaturbohrung eines Kryostaten, der einen supraleitenden Magneten enthält, leicht und in kompakter Weise möglich ist. Der Angriff der Bewegungseinrichtung kann an einem äußeren (von der mit NMR zu untersuchenden Probe entfernten Ende) erfolgen, so dass nur geringer Platz im Probenkopf benötigt wird, und insbesondere keine Vielzahl von Betätigungsgestängen oder dergleichen im Probenkopf entlang geführt werden müssen.

### Bevorzugte Ausführungsformen der Erfindung

### Ausführungsformen mit Drehelementen

Eine bevorzugte Ausführungsform der erfindungsgemäßen Anpassungseinrichtung sieht vor,
dass die beweglichen Elemente als Drehelemente ausgebildet sind, welche entlang einer gemeinsamen Achse drehbar gelagert sind und entlang der gemeinsamen Achse aufeinanderfolgend angeordnet sind, und dass die Bewegungseinrichtung weiterhin als Rotationseinrichtung ausgebildet ist, mit der eines der Drehelemente gedreht werden kann.

Die jeweils axial benachbarten Drehelemente greifen vorzugsweise in axialer Richtung ineinander, so dass diese in einem begrenzten Winkelbereich a gegeneinander verdrehbar sind.

Die erste Anschlussanordnung ist bevorzugt zum Abfahren der Drehelemente von radial außen ausgebildet, um die Kontaktelemente der Drehelemente abhängig von der Drehstellung der Drehelemente zu kontaktieren.

Diese Bauform ist besonders einfach und erlaubt einen kompakten Bau. Die gemeinsame Achse kann beispielsweise durch ein zentrales Achsbauteil oder ein geeignetes äußeres Lager, etwa mit Lagerschalen, eingerichtet werden; die Achse wird typischerweise in Längsrichtung des Probenkopfs bzw. einer Raumtemperaturbohrung eines Kryostaten ausgerichtet. Die erste Anschlussanordnung kann sich parallel zu den axial aufgereihten Drehelementen erstrecken. Von radial außen kann ein elektrischer Schleifkontakt leicht eingerichtet werden. Eine Rotation durch die Rotationseinrichtung kann motorisch einfach und kostengünstig realisiert werden. Man beachte, dass alternativ beispielsweise auch linear bewegliche Elemente vorgesehen sein können.

Bevorzugt ist eine Weiterbildung dieser Ausführungsform, bei der zumindest für einen Teil der Drehelemente, bevorzugt für alle Drehelemente, der begrenzte Winkelbereich α gleich ist, wobei für den begrenzten Winkelbereich α gilt: α=360°/(2*N). Gleiche Winkelbereiche (Drehwinkelbereiche) sind besonders einfach einzurichten und im Rahmen einer automatischen Ansteuerung der Drehelemente leicht zu programmieren. Die Drehelemente sind typischerweise alle gleich ausgebildet. Im Einzelfall kann beispielsweise das vorderste (erste) Drehelement und/oder das hinterste (letzte) anders ausgebildet sein als die anderen Drehelemente, etwa bezüglich der Anzahl N der Kontaktelemente (Kontaktflächen); in diesem Fall wird meist ebenfalls der begrenzte Drehwinkelbereich α für alle Drehelemente gleich gewählt, mit α=360°/(2*N'), mit N': Anzahl der Kontaktelemente der Mehrzahl der Drehelemente. Man beachte, dass die Drehbarkeit der Drehelemente jeweils gegenüber ihrem (axialen) Lager nicht begrenzt zu werden braucht und im Allgemeinen auch nicht begrenzt ist (ggf. mit Ausnahme eines letzten Drehelement, siehe unten).

Bei einer bevorzugten Weiterbildung ist vorgesehen, dass zumindest für einen Teil der Drehelemente, bevorzugt für alle Drehelemente, N ≥ 2 ist und die Kontaktelemente eines jeweiligen Drehelements in Umfangsrichtung gleichmäßig verteilt am Drehelement angeordnet sind. Dadurch wird zum einen ein einfacher Aufbau erreicht, und zum anderen wird (gegenüber N=1) der Drehwinkel bis zum nächsten Erreichen der ersten Anschlussanordnung durch ein Kontaktelement verringert.

Vorteilhaft ist eine Weiterbildung, die vorsieht,
dass die Anpassungseinrichtung eine zweite Anschlussanordnung zum Abfahren zumindest eines Teils der Drehelemente von radial außen aufweist, um die Kontaktelemente der Drehelemente abhängig von der Drehstellung der Drehelemente zu kontaktieren,
und dass für die Drehelemente des besagten Teils jeweils
   - die Anzahl der Kontaktelemente N≥ 2 ist,
   - und wenigstens zwei Funktionsteil-Anschlusspole eines Funktionsteils mit unterschiedlichen Kontaktelementen verbunden sind. Mittels der zweiten Anschlussanordnung kann ein elektrisches Funktionsteil vollständig elektrisch angebunden werden, was von radial außen besonders einfach möglich ist. Zudem ist es leicht möglich, die zwei für den elektrischen Kontakt genutzten Kontaktelemente gleichzeitig zu kontaktieren und zu dekontaktieren, was ein besonders sicheres Schaltverhalten ermöglicht.

Bei einer Fortentwicklung hierzu ist vorgesehen, dass
für wenigstens ein Drehelement des besagten Teils der Drehelemente
- lediglich ein elektrisches Funktionsteil im Drehelement vorhanden ist,
- N eine gerade Zahl ist,
- die elektrischen Kontaktelemente des wenigstens einen Drehelements, die in Umfangsrichtung aufeinanderfolgen, jeweils abwechselnd mit einem ersten Funktionsteil-Anschlusspol und einem zweiten Funktionsteil- Anschlusspol des elektrischen Funktionsteils ihres Drehelements verbunden sind,
   und dass die erste Anschlussanordnung und die zweite Anschlussanordnung so angeordnet sind, dass bei dem wenigstens einen Drehelement je nach Drehstellung
- entweder die beiden Anschlussanordnungen Kontaktelemente kontaktieren, die mit unterschiedlichen Funktionsteil-Anschlusspolen des elektrischen Funktionsteils verbunden sind,
- oder aber die Anschlussanordnungen beide keinen Kontakt zu einem elektrischen Kontaktelement des Drehelements haben.

Dies ermöglicht ein besonders sicheres Schaltverhalten und einen kurzen Winkelbereich zwischen aufeinanderfolgenden, elektrisch kontaktierenden Schaltstellungen, wenn die Polung des elektrischen Funktionsteils keine Rolle spielt (was insbesondere bei Kondensatoren zutrifft). Bevorzugt ist N=2, so dass die Kontaktelemente zu verschiedenen Funktionsteil-Anschlusspolen einander gegenüber liegen; entsprechend liegen dann auch die erste Anschlussanordnung und die zweite Anschlussanordnung einander gegenüber.

Bei einer anderen Weiterbildung ist vorgesehen,
dass zumindest ein Teil der Drehelemente ein Dauerkontaktelement aufweist, das mit einem ersten Funktionsteil-Anschlusspol wenigstens eines elektrischen Funktionsteils des Drehelements verbunden ist,
und dass die Anpassungseinrichtung eine Daueranschlussanordnung aufweist, die die Dauerkontaktelemente der Drehelemente des besagten Teils unabhängig von deren Drehstellung kontaktiert. Eine

Daueranschlussanordnung kommt vor allem für Umschaltanwendungen in Betracht, bei denen die Daueranschlussanordnung mit unterschiedlichen (je nach Drehstellung kontaktierten oder nicht kontaktierten) Anschlussanordnungen erfolgen soll. Die Daueranschlussanordnung kann beispielsweise als eine zentrale Achsstange durch die Drehelemente des besagten Teils verlaufen. Man beachte, dass der besagte Teil nur ein Drehelement umfassen kann (dann meist das erste oder letzte Drehelement).

Eine Fortentwicklung dieser Weiterbildung sieht vor, dass für wenigstens ein Drehelement des besagten Teils der Drehelemente
- lediglich ein elektrisches Funktionsteil im Drehelement vorhanden ist,
- und jeweils alle Kontaktelemente des Drehelements mit einem identischen, zweiten Funktionsteil-Anschlusspol des elektrischen Funktionsteils verbunden sind. Dies vereinfacht das Auf- und Abschalten der Daueranschlussanordnung am ersten Anschlusspol des elektrischen Funktionsteils durch eine entsprechende Drehstellung der (äußeren) Kontaktelemente auf die erste Anschlussanordnung. Die Drehwinkel zwischen den kontaktierenden Drehstellungen sind besonders klein.

Bei einer anderen Fortentwicklung sind für wenigstens ein Drehelement des besagten Teils der Drehelemente eine oder mehrere Hilfs-Anschlussanordnungen zum Abfahren des Drehelements von radial außen vorgesehen, um ein Kontaktelement des Drehelements abhängig von der Drehstellung des Drehelements zu kontaktieren, wobei dieses Kontaktelement mit dem zweiten Funktionsteil-Anschlusspol eines elektrischen Funktionsteils des Drehelements verbunden ist, und der erste Funktionsteil-Anschlusspol dieses elektrischen Funktionsteils mit dem Dauerkontaktelement dieses Drehelements verbunden ist,
insbesondere wobei das elektrische Funktionsteil dieses Drehelements als eine Kurzschlussbrücke ausgebildet ist. Mittels der ersten Anschlussanordnung und der oder den Hilfs-Anschlussanordnungen kann die Daueranschlussanordnung auf einfache Weise unterschiedlich verschaltet werden, etwa zum Umschalten zwischen unterschiedlichen Grundfunktionen oder Schaltungsteilen eines NMR-Probenkopfs, etwa für unterschiedliche Atomkernsorten.

Bei einer weiteren Weiterbildung weist die Anpassungseinrichtung einen ersten Drehanschlag auf, mit dem die Drehung eines axial hintersten Drehelements der Anpassungseinrichtung in einer ersten Drehrichtung begrenzt ist. Mittels der Rotationseinrichtung können die Drehelemente so weit in die erste Drehrichtung gedreht werden, dass das hinterste Drehelement am Drehanschlag anliegt und die weiteren, jeweils benachbart ineinandergreifenden Drehelemente infolge des begrenzten Winkelbereichs ebenfalls eine Endstellung erreichen ("Grundstellung"). Dadurch wird eine definierte Drehstellung all dieser Drehelemente eingenommen, von der ausgehend eine gewünschte Drehstellung der Drehelemente leicht angefahren werden kann. Es ist dann keine Vorinformation über die momentane Drehstellung der Drehelemente nötig, wenn eine neue Drehstellung der Drehelemente eingenommen werden soll. Man beachte, dass Drehanschläge nicht notwendig sind, wenn die Drehstellungen der Drehelemente problemlos (etwa automatisiert) mitverfolgt werden können.

In einer Fortentwicklung dieser Weiterbildung ist vorgesehen, dass in einer Grundstellung der Drehelemente, in der alle Drehelemente weitestmöglich in die erste Drehrichtung gedreht sind, die Kontaktelemente der Drehelemente axial fluchten, insbesondere wobei in dieser Grundstellung die erste Anschlussanordnung keinen Kontakt zu den elektrischen Kontaktelementen der Drehelemente hat. Durch die fluchtende Anordnung in der Grundstellung ist die Anpassungseinrichtung besonders einfach im Aufbau und in der Schaltbarkeit der Drehelemente. Insbesondere kann die erste Anschlussanordnung mit einem einfachen, geraden Aufbau ausgebildet werden.

Eine andere Fortentwicklung sieht vor, dass die Anpassungseinrichtung einen zweiten Drehanschlag aufweist, mit dem die Drehung des axial hintersten Drehelements in einer zweiten Drehrichtung, die entgegengesetzt zur ersten Drehrichtung ist, begrenzt ist,
insbesondere wobei sich die Drehstellungen des hintersten Drehelements am ersten Drehanschlag und am zweiten Drehanschlag um einen Winkel β unterscheiden, mit β=a. Auch über den zweiten Drehanschlag kann eine definierte Drehstellung der Drehelemente erreicht werden, von der ausgehend eine gewünschte Drehstellung der Drehelemente leicht angefahren werden kann. Die Einrichtung von erstem und zweitem Drehanschlag kann beispielsweise einfach über einen Vorsprung und eine sektorförmige Ausnehmung (bzw. einen sektorförmigen Freiraum) erfolgen. Mit β=α kann auf einfache Weise (bei minimalem β, um unnötige Schaltwege zu vermeiden), ein Ein- und Ausschalten (der Umschalten) eines elektrischen Funktionsteils im hintersten Drehelement vorgenommen werden. Allgemein kann ein Unterschied β zu β=α*(2k-1), mit k: eine natürliche Zahl ≥ 1, eingerichtet werden, um eine unterschiedliche Schaltstellung des letzten Drehelements an den beiden Anschlägen einzurichten.

Vorteilhaft ist weiterhin eine Weiterbildung, bei der die Drehelemente jeweils nach radial außen eine im Wesentlichen kreisförmige Randstruktur ausbilden, an der die Drehelemente gelagert sind, insbesondere mit einer oder mehreren gemeinsamen Lagerschalen für alle Drehelemente. Die kreisförmigen Randstrukturen können zur drehbaren Lagerung bzw. Führung der Drehelemente genutzt werden, etwa in der oder den gemeinsamen Lagerschalen, ohne dass ein zentrales Achsbauteil nötig wäre. Dies ermöglicht einen besonders einfachen Aufbau und Zusammenbau.

Bei einer anderen Weiterbildung bilden benachbarte Drehelemente an einander zugewandten Grundflächen wenigstens einen, bevorzugt zwei, axiale Vorsprünge aus, die in wenigstens eine, bevorzugt zwei, axiale Vertiefungen eingreifen, insbesondere wobei die axialen Vorsprünge und/oder die axialen Vertiefungen im Wesentlichen sektorförmig ausgebildet sind. Dies ist eine besonders einfache Möglichkeit für einen gegenseitigen Eingriff, durch den der Winkelbereich α begrenzt werden kann.

### Weitere Ausführungsformen

Bei einer bevorzugten Ausführungsform einer erfindungsgemäßen Anpassungseinrichtung greift die Bewegungseinrichtung an einem in der Abfolge der beweglichen Elemente vordersten beweglichen Element an. Dadurch ist es möglich, mittels der Bewegungseinrichtung alle beweglichen Elemente zu betätigen und die beweglichen Elemente in voneinander unabhängige Bewegungsstellungen zu bringen. Man beachte, dass für die Einstellung typischerweise mit dem hintersten beweglichen Element begonnen wird, und dann nach vorne hin die weiteren beweglichen Elemente eingestellt werden.

Bevorzugt ist ebenfalls eine Ausführungsform, bei der die Anpassungseinrichtung einen ersten Anschlag aufweist, mit dem die Bewegung eines in der Abfolge der beweglichen Elemente hintersten beweglichen Elements der Anpassungseinrichtung in einer ersten Bewegungsrichtung begrenzt ist. Mittels der Bewegungseinrichtung können die beweglichen Elemente so weit in die erste Bewegungsrichtung bewegt werden, dass das hinterste bewegliche Element am ersten Anschlag anliegt und die weiteren, jeweils benachbart ineinandergreifenden beweglichen Elemente infolge des begrenzten Bereichs für eine gegenseitige Bewegung ebenfalls eine Endstellung erreichen ("Grundstellung"). Dadurch wird eine definierte Bewegungsstellung all dieser beweglichen Elemente eingenommen, von der ausgehend eine gewünschte Bewegungsstellung der beweglichen Elemente leicht angefahren werden kann. Es ist dann keine Vorinformation über die momentane Bewegungsstellung der beweglichen Elemente nötig, wenn eine neue Bewegungsstellung der beweglichen Elemente eingenommen werden soll. Man beachte, dass Anschläge nicht notwendig sind, wenn die Bewegungsstellungen der beweglichen Elemente problemlos (etwa automatisiert) mitverfolgt werden können.

Bei einer Weiterbildung dieser Ausführungsform weist die Anpassungseinrichtung weiterhin einen zweiten Anschlag auf, mit dem die Bewegung des in der Abfolge der beweglichen Elemente hintersten beweglichen Elements der Anpassungseinrichtung in einer zweiten Bewegungsrichtung, die der ersten Bewegungsrichtung entgegengesetzt ist, begrenzt ist. Auch über den zweiten Anschlag kann eine definierte Bewegungsstellung der beweglichen Elemente erreicht werden, von der ausgehend eine gewünschte Bewegungsstellung der beweglichen Elemente leicht angefahren werden kann.

Bevorzugt ist weiterhin eine Ausführungsform, bei der zumindest ein Teil der beweglichen Elemente mit elektrischen Funktionsteilen mit identischer elektrischer Funktion, aber mit unterschiedlicher Magnitude ausgebildet ist. Dadurch kann die elektrische Funktion in einem weiten Magnitudenbereich mit feiner Unterteilung zur Verfügung gestellt werden. Beispielsweise kann ein Teil der beweglichen Elemente mit Kondensatoren ausgebildet sein, die eine jeweils unterschiedliche Kapazität (also unterschiedliche Magnitude der Kapazität) haben. Es ist aber auch möglich, unterschiedliche elektrische Funktionen (etwa Kondensator und Spule) zu mischen, oder bei gleicher elektrischer Funktion mehrere gleiche Magnituden (etwa gleiche Kapazitäten) vorzusehen.

Eine vorteilhafte Weiterbildung dieser Ausführungsform sieht vor, dass unterschiedliche Magnituden gemäß einer binären Reihe vorgesehen sind, wobei jede der unterschiedlichen Magnituden in einem elektrischen Funktionsteil eines anderen beweglichen Elements eingerichtet ist. In der binären Reihe verdoppeln sich jeweils die Magnituden. Mittels der binären Reihe ist es möglich, alle Zwischenwerte von Magnituden in Schritten der kleinsten, an einem der elektrischen Funktionsteile eingerichteten Magnitude einzustellen.

Vorteilhaft ist weiterhin eine Ausführungsform, bei der die elektrischen Funktionsteile zumindest eines Teils der beweglichen Elemente, insbesondere aller beweglichen Elemente, Kondensatoren sind. Kondensatoren sind kompakt, kostengünstig, wenig störungsanfällig und über einen großen Magnitudenbereich erhältlich, so dass Resonanzfrequenzen des HF-Resonanzkreises in einem weiten Bereich eingestellt werden können.

Bevorzugt ist auch eine Ausführungsform, bei der die erste Anschlussanordnung und/oder eine zweite Anschlussanordnung zumindest einen Teil der beweglichen Elemente, insbesondere alle beweglichen Elemente, elektrisch in Parallelschaltung kontaktiert. Dadurch können die elektrischen Funktionsteile der beweglichen Elemente einfach zu- und abgeschaltet werden, um die Gesamtschaltung einzustellen. Eine etwaige Hilfs-Anschlussanordnung ist in der Regel zur ersten und zweiten Anschlussanordnung in Serie geschaltet.

Ebenfalls bevorzugt ist eine Ausführungsform, bei der die erste Anschlussanordnung und/oder eine zweite Anschlussanordnung eine Vielzahl von Anschlussfedern ausbildet, die jeweils auf eine Außenseite eines beweglichen Elements drücken, insbesondere wobei die Anschlussfedern jeweils auf eine radiale Außenseite eines Drehelements drücken und axial fluchten. Mittels der Anschlussfedern kann auf einfache Weise ein sehr zuverlässiger elektrischer Kontakt eingerichtet werden; mittels die Feder kann durch elastische Verformung eine (Mindest-)Kraft eingerichtet werden, die den Kontakt aufrecht erhält.

Besonders bevorzugt ist eine Weiterbildung dieser Ausführungsform, bei der eine Anschlussfeder jeweils mehrere Anschlussfinger, insbesondere vier oder mehr Anschlussfinger, ausbildet, die auf die Außenseite eines beweglichen Elements drücken, und die bei geeigneter Bewegungsstellung des beweglichen Elements gleichzeitig dasselbe elektrische Kontaktelement kontaktieren können. Durch die Anschlussfinger kann die Zuverlässigkeit des elektrischen Kontakts weiter verbessert werden. Einzelne Unebenheiten an den beweglichen Elementen können durch die Finger ausgeglichen werden.

Eine andere Ausführungsform sieht vor, dass die Anpassungseinrichtung einen Rastmechanismus umfasst, mit dem die beweglichen Elemente jeweils in verschiedenen Bewegungsstellungen federnd verrastet werden können, insbesondere wobei die beweglichen Elemente als Drehelemente ausgebildet sind und für jedes Drehelement jeweils 2*N verschiedene verrastbare Drehstellungen, die voneinander um einen Verdrehschrittwinkel γ verschieden sind, vorgesehen sind, mit γ=360°/(2*N). Durch die Verrastung wird die Einstellung von gewünschten Bewegungsstellungen der einzelnen beweglichen Elemente besonders zuverlässig. Mittels der 2*N Drehstellungen kann zwischen zwei Stellungen auf Kontaktelementen jeweils eine isolierende Zwischenstellung eingerichtet werden, um das Drehelement bzw. ein zugehöriges elektrisches Funktionsteil abzuschalten

Vorteilhaft ist auch eine Weiterbildung einer Anpassungseinrichtung mit Anschlussfedern und Rastmechanismus, die vorsieht, dass der Rastmechanismus mit Vertiefungen an Außenseiten der beweglichen Elemente, insbesondere an radialen Außenseiten von Drehelementen, ausgebildet ist, in die die Anschlussfedern eingreifen. Dadurch kann sehr einfach ein Rastmechanismus eingerichtet werden, wobei die Anschlussfedern eine Doppelfunktion (elektrischer Kontakt und Verrastung) ausüben. Vertiefungen werden typischerweise auf einer radialen Außenseite der Drehelemente an den Kontaktelementen und bevorzugt auch mittig zwischen den Kontaktelementen (oder bei nur einem Kontaktelement gegenüber dem Kontaktelement) ausgebildet.

Bei einer bevorzugten Ausführungsform weisen die beweglichen Elemente einen Grundkörper aus elektrisch isolierendem Material, insbesondere Kunststoff, auf, wobei die elektrischen Funktionsteile benachbarter beweglicher Elemente durch eine Schicht des isolierenden Materials wenigstens eines der Grundkörper der benachbarten beweglichen Elemente voneinander separiert sind,
insbesondere wobei die beweglichen Elemente als Drehelemente ausgebildet sind und bei einem jeweiligen Drehelement der Grundkörper das elektrische Funktionsbauteil vollständig umschließt und die N elektrischen Kontaktelemente auf beiden axialen Seiten radial überragt. Durch diese Bauform kann eine zuverlässige gegenseitige elektrische Isolation der elektrischen Funktionsteile benachbarter beweglicher Elemente erreicht werden.

### Erfindungsgemäße Probenköpfe

In den Rahmen der vorliegenden Erfindung fällt auch ein NMR-Probenkopf, der einen HF-Resonanzkreis mit einer HF-Resonatorspule und eine erfindungsgemäße, oben beschriebene Anpassungseinrichtung aufweist. Die Anpassungseinrichtung ist kompakt und kann den NMR-Probenkopf bzw. den HF-Resonanzkreis an unterschiedliche Messaufgaben anpassen, etwa unterschiedliche Atomkerntypen oder unterschiedliche Magnetfeldstärken. Der NMR-Probenkopf kann vielseitig zur Aufnahme von NMR-Spektren eingesetzt werden.

Bei einer bevorzugten Ausführungsform eines erfindungsgemäßen NMR-Probenkopfs umfasst der Probenkopf weiterhin einen Hauptschalter, mit dem die Anpassungseinrichtung insgesamt in den HF-Resonanzkreis geschaltet oder vom HF-Resonanzkreis getrennt werden kann, insbesondere wobei durch den Hauptschalter die Anpassungseinrichtung im HF-Resonanzkreis durch eine oder mehrere Alternativschaltungen ersetzt werden kann. Durch die Abschaltung der Anpassungseinrichtung insgesamt können Störungen im Probenkopf minimiert werden, wenn die Anpassungseinrichtung für ein bestimmtes Experiment nicht benötigt werden sollte, und gegebenenfalls stattdessen eine Alternativschaltung.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden, sofern dadurch der durch die Ansprüche definierte Schutzbereich der Erfindung nicht verlassen wird. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: eine schematische Ansicht einer Ausführungsform einer erfindungsgemäßen Anpassungseinrichtung;
- Fig. 2: einen schematische Teilansicht der Anpassungseinrichtung von Fig. 1, ohne Lagerschalen;
- Fig. 3: einen schematische Teilansicht der Anpassungseinrichtung von Fig. 1, mit einer Lagerschale;
- Fig. 4: eine schematische Ansicht eines beweglichen Elements, hier Drehelements, für die Erfindung;
- Fig. 5a: eine schematische Ansicht einer ineinander greifenden Abfolge von hier fünf Drehelementen, für die Erfindung;
- Fig. 5b: die Abfolge von Drehelementen von Fig. 5a, in Explosionsdarstellung;
- Fig. 6a-6d: die Abfolge von Drehelementen von Fig. 5a, in verschiedenen Drehstellungen der Drehelemente bei Betätigung über das vorderste Drehelement;
- Fig. 7: eine schematische Darstellung eines Drehelements, bei Kontaktierung durch Anschlussfedern einer ersten und zweiten Anschlussanordnung, für die Erfindung;
- Fig. 8: ein Funktionsschema eines Drehelements für die Erfindung, mit zwei Kontaktelementen und einem Kondensator als elektrischem Funktionsteil;
- Fig. 9a: ein Funktionsschema eines Drehelements für die Erfindung, mit vier Kontaktelementen und zwei Kondensatoren als elektrischen Funktionsteilen, für Verdrehschritte von 90°;
- Fig. 9b: ein Funktionsschema eines Drehelements für die Erfindung, mit vier Kontaktelementen und zwei Kondensatoren als elektrischen Funktionsteilen, für Verdrehschritte von 60°;
- Fig. 10a: ein Funktionsschema eines Drehelements für die Erfindung, mit Vertiefungen für zwei Kontaktelemente und für zwei Zwischenpositionen sowie mit erstem und zweitem Drehanschlag;
- Fig. 10b: das Drehelement von Fig. 10a, in um 90° verdrehter Drehstellung;
- Fig. 11: das Drehelement von Fig. 10a, jedoch ohne Drehanschläge;
- Fig. 12: ein Funktionsschema eines Drehelements für die Erfindung, mit einem Kontaktelement und einem Dauerkontaktelement;
- Fig. 13: eine schematische Darstellung eines weiteren Drehelements mit Dauerkontaktelement, für die Erfindung;
- Fig. 14: eine schematische Darstellung eines erfindungsgemäßen NMR-Probenkopfs, mit einer erfindungsgemäßen Anpassungseinrichtung;
- Fig. 15: eine schematische Darstellung eines HF-Resonanzkreises mit einer erfindungsgemäßen Anpassungseinrichtung;
- Fig. 16: ein Ersatzschaltbild einer Ausführungsform einer erfindungsgemäßen Anpassungseinrichtung für den HF-Resonanzkreis von Fig. 15.

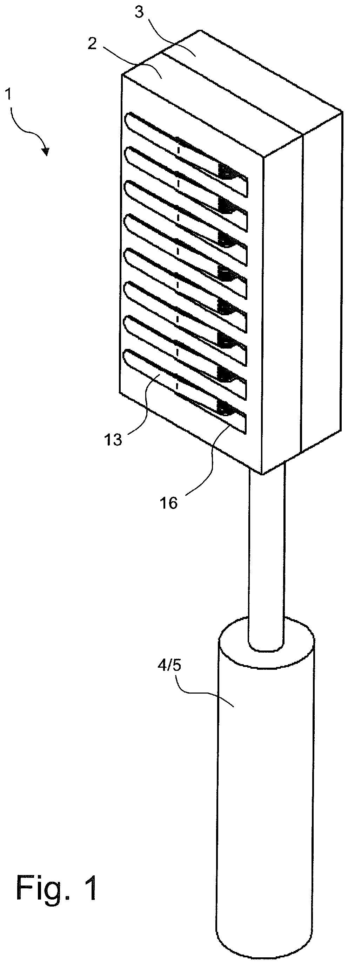

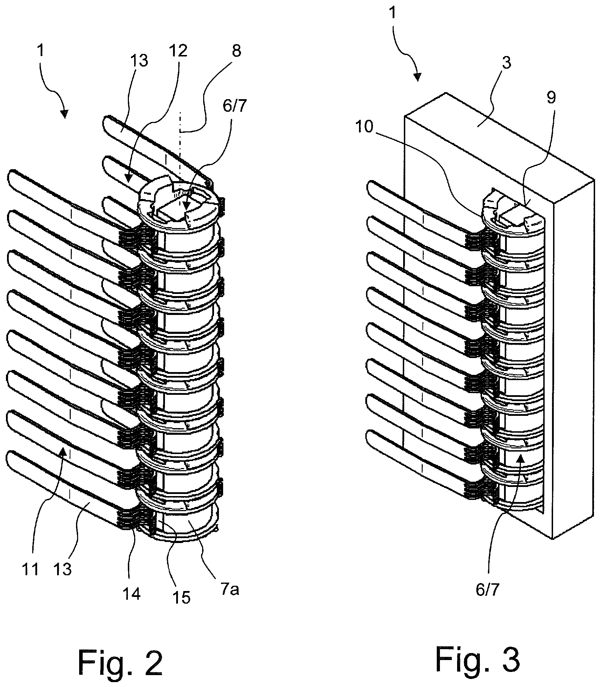

Die **Fig. 1** zeigt in einer schematischen Schrägansicht eine Ausführungsform einer erfindungsgemäßen Anpassungseinrichtung 1 mit zwei Lagerschalen 2, 3 und einer Bewegungseinrichtung 4, hier einer Rotationseinrichtung 5. **Fig. 2** zeigt hierzu eine Teilansicht ohne die Lagerschalen 2, 3 und die Bewegungseinrichtung 4, und **Fig. 3** eine weitere Teilansicht mit nur einer Lagerschale 3 und ohne die Bewegungseinrichtung 4.

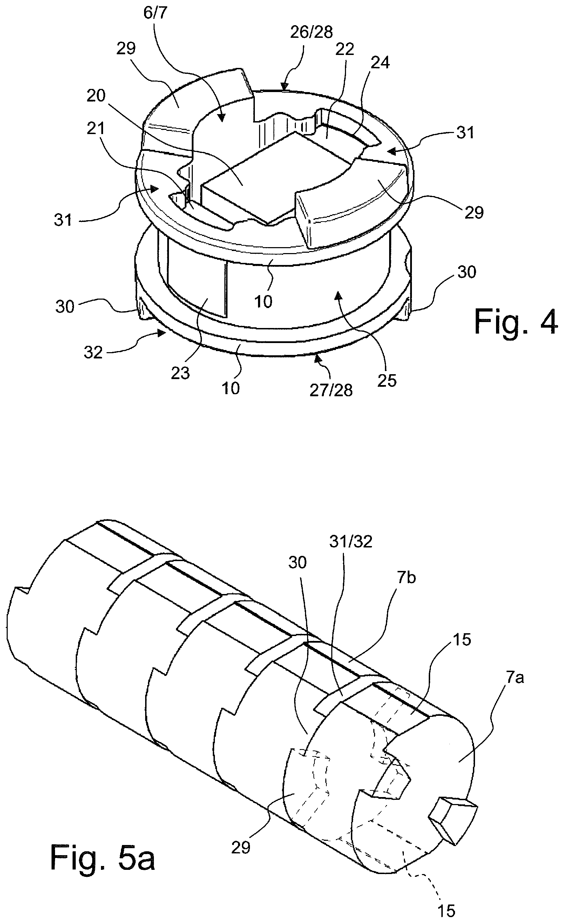

Die Anpassungseinrichtung 1 umfasst eine Abfolge von beweglichen Elementen 6, hier Drehelementen 7, die entlang einer Achse 8 aufeinanderfolgend angeordnet sind, wobei jeweils benachbarte Drehelemente 7 mechanisch ineinandergreifen (vgl. dazu auch Fig. 4 und Fig. 5a unten). Die Drehelemente 7 sind um die Achse 8 einzeln drehbar gelagert. Zu diesem Zweck sind in den Lagerschalen 2, 3 Vertiefungen 9 ausgebildet, die im Wesentlichen die Form eines entlang seiner Zylinderachse halbierten Kreiszylinders aufweisen. In diesen Vertiefungen 9 können kreisförmige Randstrukturen 10 der Drehelemente 7 abgleiten, wenn die Drehelemente 7 um die Achse 8 rotieren.

Ein vorderstes (in Fig. 2 unterstes) Drehelement 7a der Abfolge von Drehelementen 7 ist durch die Rotationseinrichtung 5 antreibbar, und insbesondere in jede Drehrichtung in definierter Weise drehbar, hier mittels eines elektrischen Stellmotors (nicht näher dargestellt).

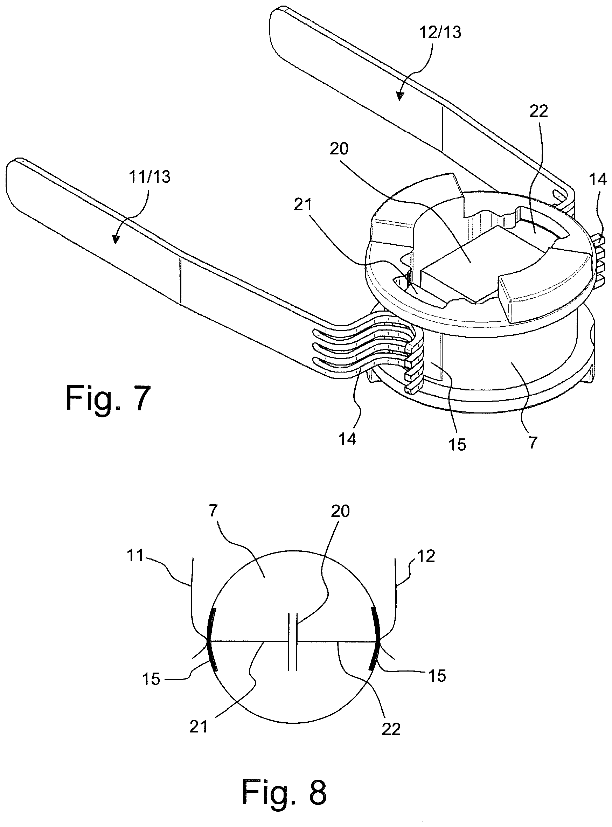

Die Anpassungseinrichtung 1 umfasst weiterhin eine erste Anschlussanordnung 11, die hier mit acht axial fluchtenden Anschlussfedern 13 ausgebildet ist, und eine zweite Anschlussanordnung 12, die hier ebenfalls mit acht axial fluchtenden Anschlussfedern 13 ausgebildet ist. Die Anschlussfedern 13 sind hier jeweils mit vier Anschlussfingern 14 ausgebildet (siehe Fig. 7), mit denen Kontaktelemente 15 der beweglichen Elemente 6 kontaktiert werden können (siehe hierzu Fig. 4). In den Lagerschalen 2, 3 sind hier Durchbrüche 16 vorgesehen, um Raum für die Anschlussfedern 13 zu schaffen.

**Fig. 4** erläutert ein bewegliches Element 6, hier ein Drehelement 7, wie es in der Anpassungseinrichtung von Fig. 1 verbaut werden kann, näher.

Das Drehelement 7 weist in der gezeigten Ausführungsform ein elektrisches Funktionsteil 20 mit zwei Funktionsteil-Anschlusspolen 21, 22 auf. Das elektrische Funktionsteil 20 ist hier ist hier mit einem Kondensator (durch ein Gehäuse des Funktionsteils 20 verdeckt) ausgebildet. Weiterhin weist das Drehelement 7 zwei nach radial außen gerichtete elektrische Kontaktelemente 23, 24 auf. Der Funktionsteil-Anschlusspol 21 ist mit dem Kontaktelement 23 elektrisch verbunden, und der Funktionsteil-Anschlusspol 22 ist mit dem (in Fig. 4 größtenteils verdeckten) Kontaktelement 24 verbunden. Die Kontaktelemente 23, 24 bestehen typischerweise aus Kupfer oder einem anderen gut elektrisch leitfähigen Metall.

Das Drehelement 7 verfügt über einen Grundkörper 25 aus elektrisch isolierendem Material, insbesondere aus Kunststoff. Der Grundkörper 25 umschließt allseitig das elektrische Funktionsteil 20, insbesondere auch auf einer Oberseite 26 und Unterseite 27 des Drehelements 7. In Fig. 4 ist dabei an der Oberseite 26 jedoch eine Abdeckung geöffnet dargestellt, um das Funktionsteil 20 sehen zu können (vgl. Fig. 5a für den abgedeckten Zustand). Der Grundkörper 25 bildet an der Oberseite 26 und der Unterseite 27 jeweils eine kreisförmige Randstruktur 10 aus, die die Kontaktelemente 23, 24 radial überragt. Dadurch kann insgesamt eine gute Spannungsfestigkeit erreicht werden.

Ebenfalls durch den Grundkörper 25 werden weiterhin an der Oberseite 26 zwei sektorförmige Vorsprünge 29 ausgebildet, die über einer oberseitigen Grundfläche 28 axial hervorstehen. Ebenso werden an der Unterseite 27 zwei sektorförmige Vorsprünge 30 ausgebildet, die über eine unterseitige Grundfläche 28 axial hervorstehen. Zwischen den Vorsprüngen 29 verbleiben Vertiefungen 31, und zwischen den Vorsprüngen 30 verbleiben Vertiefungen 32 (in Fig. 4 zum Teil verdeckt).

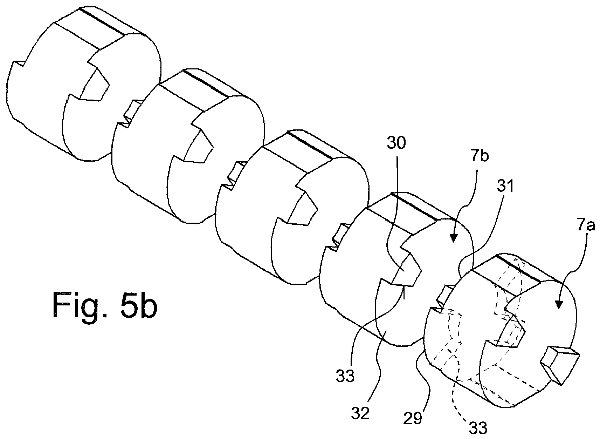

Durch die Vorsprünge 29, 30 und Vertiefungen 31, 32 kann, wie in Fig. 5a und Fig. 5b ersichtlich ist, bei einer Abfolge von Drehelementen 7 ein gegenseitiger Eingriff eingerichtet werden, durch den eine relative Verdrehbarkeit von benachbarten Drehelementen 7 begrenzt ist. Dies soll an den Drehelementen 7a und 7b erläutert werden.

Die Vorsprünge 29 des vordersten (ersten) Drehelements 7a greifen in die Vertiefungen 32 des zweiten Drehelements 7b ein. Umgekehrt greifen die Vorsprünge 30 des zweiten Drehelements 7b in die Vertiefungen 31 des vordersten Drehelements 7a ein. Die sich in radialer Richtung erstreckenden Seitenflächen 33 der Vorsprünge 29, 30 der Drehelemente 7a, 7b bilden füreinander gegenseitige Anschläge aus, wodurch (im Eingriff, wie in Fig. 5a dargestellt) die gegenseitige Verdrehbarkeit begrenzt ist. Der zugehörige Winkelbereich (Verdrehbereich) entspricht dabei dem Winkelintervall einer Vertiefung minus dem Winkelintervall des eingreifenden Vorsprungs.

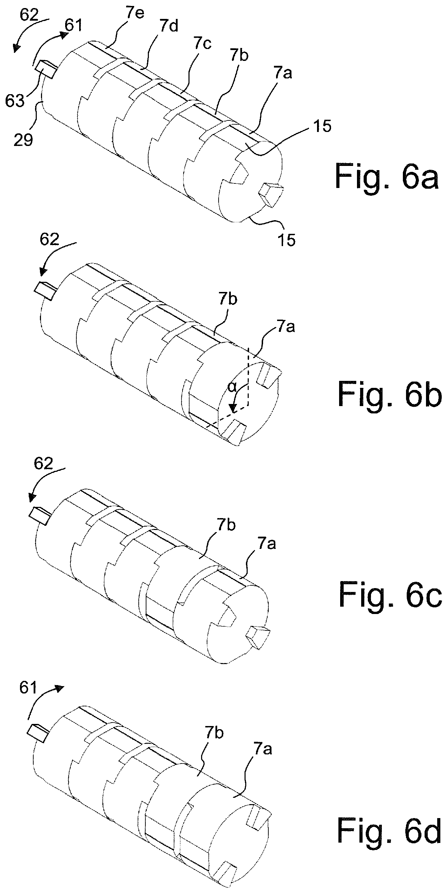

Die Größen (Winkelintervalle) der Vorsprünge 29, 30 und der Vertiefungen 31, 32 sind hier so bemessen, dass die Drehelemente 7a, 7b um einen Winkelbereich α von 90° gegeneinander verdrehbar sind (siehe dazu insbesondere Fig. 6b), entsprechend 360°/(2*N), mit N=2 (Anzahl der Kontaktelemente 15 eines Drehelements 7a).

Im Folgenden soll erläutert werden, wie bei einer Abfolge von ineinander greifenden Drehelementen 7a-7e, wie in **Fig. 6a** dargestellt, bei verschiedenen Drehelementen 7a-7b jeweils eine gewünschte Drehstellung eingerichtet wird; die Drehstellungen entsprechen elektrischen Schaltpositionen.

Dabei ist das vorderste Drehelement 7a über eine Rotationseinrichtung (nicht dargestellt, vgl. aber Fig. 1) verdrehbar. Die Drehelemente 7a-7e verfügen hier jeweils über zwei einander gegenüberliegende Kontaktelemente 15 (teilweise verdeckt) und können gegeneinander um α=90° verdreht werden. Die Polung der Kontaktelemente 15 sei unwichtig (was insbesondere bei Kondensatoren als elektrischen Funktionsteilen zutrifft), so dass es eine Unterscheidung von Drehstellungen mit den Kontaktelementen 15 vertikal ausgerichtet und mit den Kontaktelementen 15 horizontal gerichtet genügt.

Am einfachsten wird die Abfolge zunächst in eine definierte Ausgangsposition gebracht, wie in Fig. 6a dargestellt, gebracht. Das vorderste Drehelement 7a wurde hier so weit wie möglich in eine erste Drehrichtung 61 gedreht, bis ein hinterstes (letztes) Drehelement 7e durch einen ersten Drehanschlag 63, der hier mit dem Vorsprung 29 des Drehelements 7e zusammenwirkt, festgelegt wird. In dieser Ausgangsposition fluchten alle Kontaktelemente 15 der Drehelemente 7a-7e, bei vertikal ausgerichteten Kontaktelementen 15.

Sodann wird geprüft, ob das hinterste Drehelement 7e in seiner gewünschten Drehstellung ist oder nicht. Falls nicht, wird das vorderste Drehelement 7a entgegen der zuletzt verwendeten Drehrichtung (also in eine zweite Drehrichtung 62) gedreht, bis das hinterste Drehelement 7e in die gewünschte Drehstellung gebracht ist. Falls das hinterste Drehelement 7e bereits in der gewünschten Drehstellung ist, kann mit der Dreheinstellung des vorletzten Drehelements 7d fortgefahren werden. Falls dessen Drehstellung verändert werden muss, wird wiederum das vorderste Drehelement 7a entgegen der zuletzt verwendeten Drehrichtung gedreht, bis die gewünschte Drehstellung erreicht ist. Sodann wird mit dem nächsten, nach vorne benachbarten Drehelement 7c fortgefahren, und so fort.

Im vorliegenden Beispiel seien die Drehelemente 7e, 7d und 7c in Fig. 6a bereits in gewünschten Drehstellungen (vertikal ausgerichtet). Jedoch sollen die Drehelemente 7b, 7a in die andere Drehstellung (horizontal ausgerichtet) verbracht werden.

Entsprechend wird zunächst das vorderste Drehelement 7a in die zweite Drehrichtung 62 gedreht. In einem ersten Verstellschritt, vgl. **Fig. 6b****,** wird das Drehelement 6a zunächst um den Winkelbereich α von 90° gedreht, den das erste Drehelement 7a "Spiel" gegenüber dem zweiten Drehelement 7b hat.

Bei Drehung eines weiteren Verstellschritts in die zweite Drehrichtung 62 nimmt das erste Drehelement 7a das zweite Drehelement 7b mit, vgl. **Fig. 6c****.** Das zweite Drehelement 7b hat dadurch die gewünschte Drehstellung (horizontal ausgerichtet) erreicht. Jedoch steht das erste Drehelemnt 7a falsch.

Daher wird nun das vorderste Drehelement 7a einen Schritt zurück in die erste Drehrichtung 61 gedreht, vgl. **Fig. 6d****.** Entsprechend seinem "Spiel" nimmt das erste Drehelement 7a dabei das zweite Drehelement 7b nicht mit. Danach ist die gewünschte Drehstellung aller Drehelemente 7a-7e erreicht.

Durch die Drehstellung eines Drehelements 7 wird bestimmt, ob und ggf. welche Kontaktelemente 15 des Drehelements 7 von einer ersten und ggf. zweiten Anschlussanordnung 11, 12 elektrisch kontaktiert werden, vgl. hierzu **Fig. 7****.**

In der gezeigten Ausführungsform liegt eine jeweilige Anschlussfeder 13 von radial außen am Drehelement 7 an; dabei drückt die Anschlussfeder 13 durch elastische Vorspannung leicht auf das Drehelement 7. Bei entsprechender Drehstellung des Drehelements 7 (die in Fig. 7 gezeigt ist) berührt die Anschlussfeder 13 ein Kontaktelement 15, wodurch ein elektrischer Kontakt zu einem Anschlusspol 21, 22 eines elektrischen Funktionsteils 20 hergestellt wird. Für einen besonders zuverlässigen elektrischen Kontakt weist die Anschlussfeder 13 hier vier Anschlussfinger 14 auf, die gleichzeitig das Kontaktelement 15 berühren. Die Anschlussfeder 13 bzw. die Anschlussfinger 14 sind hier abgerundet ausgebildet, ebenfalls um den elektrischen Kontakt zu verbessern.

Durch Verdrehen des Drehelements 7 kann die Berührung des Kontaktelements 15 aufgehoben werden, also das elektrische Funktionsteil 20 elektrisch isoliert werden. Dies soll nachfolgend näher erläutert werden.

**Fig. 8** zeigt schematisch ein einfaches Drehelement 7 für die Erfindung im Querschnitt. Das Drehelement 7 ist mit einem elektrischen Funktionsteil 20, hier einem Kondensator ausgestattet, dessen Funktionsteil-Anschlusspole 21, 22 auf zwei einander gegenüberliegende Kontaktelemente 15 gelegt sind. In der gezeigten Drehstellung ist das elektrische Funktionsteil 20 aktiv, da die Anschlussanordnungen 11, 12 die Kontaktelemente 15 berühren.

Durch eine 90°-Drehung (nicht gezeigt) würde das elektrische Funktionsteil 20 hingegen elektrisch isoliert bzw. abgeschaltet.

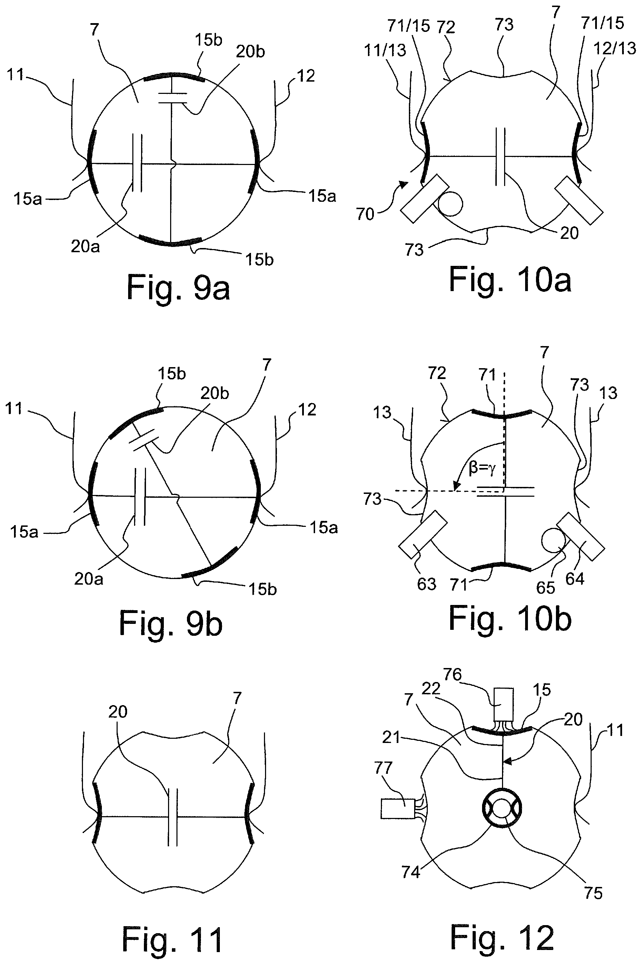

Das Drehelement von **Fig. 9a** ist hingegen mit zwei elektrischen Funktionsteilen 20a, 20b ausgestattet, hier Kondensatoren unterschiedlicher Kapazität. Das elektrische Funktionsteil 20a ist auf die einander gegenüberliegenden Kontaktelemente 15a geschaltet. Hingegen ist das elektrische Funktionsteil 20b auf die einander gegenüberliegenden Kontaktelemente 15b geschaltet. In der gezeigten Drehstellung ist das elektrische Funktionsteil 20a aktiv, da die Anschlussanordnungen 11, 12 die Kontaktelemente 15a berühren. Durch eine 90°-Drehung (nicht gezeigt) des Drehelements 7 würde stattdessen das elektrische Funktionsteil 20b aktiv, da dann die Kontaktelemente 15b durch die Anschlussanordnungen 11, 12 berührt würden.

Das Drehelement 7 von **Fig. 9b** ist ebenfalls mit zwei elektrischen Funktionsteilen 20a, 20b aufgebaut, die jeweils über einander gegenüberliegende Kontaktelemente 15a, 15b elektrisch kontaktiert werden können. Durch Drehschritte von jeweils 60° kann hier zwischen den beiden elektrischen Funktionsteilen 20a, 20b und einer isolierten (elektrisch unterbrochenen) Drehstellung umgeschaltet werden.

Das in **Fig. 10a** gezeigte Drehelement 7 entspricht weitgehend dem Drehelement von Fig. 8, so dass hier nur die wesentlichen Unterschiede erläutert werden.

Am Drehelement 7 ist hier ein Rastmechanismus 70 ausgebildet. Dieser nutzt die Federkraft der Anschlussfedern 13 der Anschlussanordnungen 11, 12. Die Anschlussfedern 13 greifen in Vertiefungen 71 ein, die durch die Kontaktelemente 15 an der radialen Außenseite 72 des Drehelements 7 ausgebildet werden. Dadurch muss eine Kraft (entgegen der Federkraft der Anschlussfedern 13) aufgebracht werden, um die in Fig. 10 gezeigte Drehstellung zu verlassen. Dadurch wird diese Drehstellung (Drehposition) mit aktivem elektrischen Funktionsteil 20 "verrastet".

An der Außenseite 72 des Drehelements 7 sind weiterhin Vertiefungen 73 ausgebildet, die um hier γ=90° gegenüber den Vertiefungen 71 versetzt sind; der Winkel γ wird auch als Verdrehschrittwinkel bezeichnet, vgl. **Fig. 10b**. Nach Drehung um diesen Verdrehschrittwinkel γ greifen die Anschlussfedern 13 in diese Vertiefungen 73 ein, wodurch auch diese Drehstellung (Drehposition) mit nicht-aktivem elektrischen Funktionsteil 20 "verrastet". Die Anschlussfedern 13 greifen in dieser Drehstellung in die elektrisch isolierten Vertiefungen 73 ein, die zwischen den Vertiefungen 71 der Kontaktelemente 15 liegen ("Zwischenstellung" oder "Zwsichenposition").

Das Drehelement 7 ist hier weiterhin in seinem Drehvermögen durch einen (festen) ersten Drehanschlag 63 und einen (festen) zweiten Drehanschlag 64 begrenzt; typischerweise werden diese festen Drehanschläge 63, 64 für ein letztes Drehelement in einer Abfolge eingesetzt. Die Drehanschläge 63, 64 wirken hier mit einem axial vorstehenden Anschlagbolzen 65 des Drehelements 7 zusammen. Zwischen den Drehanschlägen 63, 64 ist das Drehelement 7 um einen Winkel β von hier ebenfalls 90° verdrehbar.

Die **Fig. 11** zeigt ein Drehelement 7 entsprechend Fig. 10a, wobei jedoch keine Drehanschläge vorgesehen sind. Das Drehelement 7 kann beispielsweise als vorderstes oder eines der mittleren Drehelemente einer Abfolge von Drehelementen eingesetzt werden. Durch Drehungen um Verstellschrittwinkel γ von jeweils 90° sind hier vier verschiedene verrastete Drehstellungen (Rastpositionen) des Drehelements 7 möglich, wobei das Drehelement 7 für sich beliebig weit in jede Drehrichtung verstellt werden kann (solange eingreifende andere Drehelemente nicht begrenzend wirken). Nach jeweils einem Verstellschritt von γ=90° wird die Funktion (elektrisches Funktionsteil 20 aktiv bzw. inaktiv) gewechselt, und nach zwei Verstellschritten von insgesamt 180° wird wieder die gleiche Funktion erreicht.

Das in **Fig. 12** gezeigte Drehelement 7 verfügt über ein Dauerkontaktelement 74, welches eine Daueranschlussanordnung 75 stets (unabhängig von der Drehstellung des Drehelements 7) berührt und dadurch einen elektrischen Kontakt herstellt. Die Daueranschlussanordnung 75 ist hier mit einem axial verlaufenden Metallstab ausgebildet. Das Dauerkontaktelement 74 ist hier mit zwei Kontaktfedern ausgebildet, die leicht an den zwischen ihnen liegenden Metallstab drücken.

Das Drehelement 7 verfügt hier über ein einziges, radial nach außen gerichtetes elektrisches Kontaktelement 15. Als elektrisches Funktionsteil 20 ist hier eine Kurzschlussbrücke vorgesehen, dessen erster Funktionsteil-Anschlusspol 21 auf das Dauerkontaktelement 74 und dessen zweiter Funktionsteil-Anschlusspol 22 auf das Kontaktelement 15 gelegt sind.

Je nach Drehstellung des Drehelements 7 kann das Kontaktelement 15 die erste Anschlussanordnung 11, eine erste Hilfs-Anschlussanordnung 76 (wie in Fig. 12 gezeigt), eine zweite Hilfs-Anschlussanordnung 77 oder auch "nichts" kontaktieren; die Drehstellungen unterscheiden sich dabei jeweils um Verdrehwinkel von 90°.

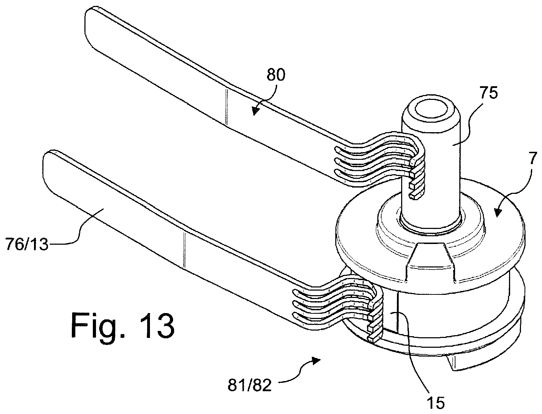

In der **Fig. 13** ist ein Drehelement 7 für eine erfindungsgemäße Anpassungseinrichtung gezeigt, bei der eine Daueranschlussanordnung 75 als axialer Metallstab ausgebildet ist, der in das Drehelement 7 hineinragt und unabhängig von der Drehstellung des Drehelements 7 eine elektrische Verbindung zu einem ersten Funktionsteil-Anschlusspol des elektrischen Funktionsteils (in Fig. 13 verdeckt) des Drehelements 7 hat. In der gezeigten Ausführungsform liegt eine Anschlussfeder 80 an der Daueranschlussanordnung 75 an, über die eine weitere elektrische Verbindung bzw. Verschaltung erfolgt. Weiterhin verfügt das Drehelement 7 über ein radial nach außen gerichtetes Kontaktelement 15, das über eine Anschlussfeder 13 einer Hilfs-Anschlussanordnung 76 abhängig von der Drehstellung kontaktiert werden kann. Das Kontaktelement 15 hat eine elektrische Verbindung zu einem zweiten Funktionsteil-Anschlusspol des elektrischen Funktionsteils (wiederung verdeckt in Fig. 13).

Das gezeigte Drehelement 7 wird typischerweise als ein Ein/Aus-Schalter 81 eingesetzt (wobei das elektrische Funktionsteil dann in der Regel eine Kurzschlussbrücke oder ein niederohmiger Widerstand ist), beispielsweise um eine in Reihe nachgeschaltete Gesamtheit von weiteren Drehelementen (nicht dargestellt) mit elektrischen Funktionsteilen der Anpassungseinrichtung ein- und auszuschalten; in letzterem Fall wird das Drehelement 7 als "Hauptschalter" 82 genutzt. Das gezeigte Drehelement 7 ist dann meistens ein vorderstes oder letztes Drehelement in der Abfolge von ineinander greifenden Drehelementen.

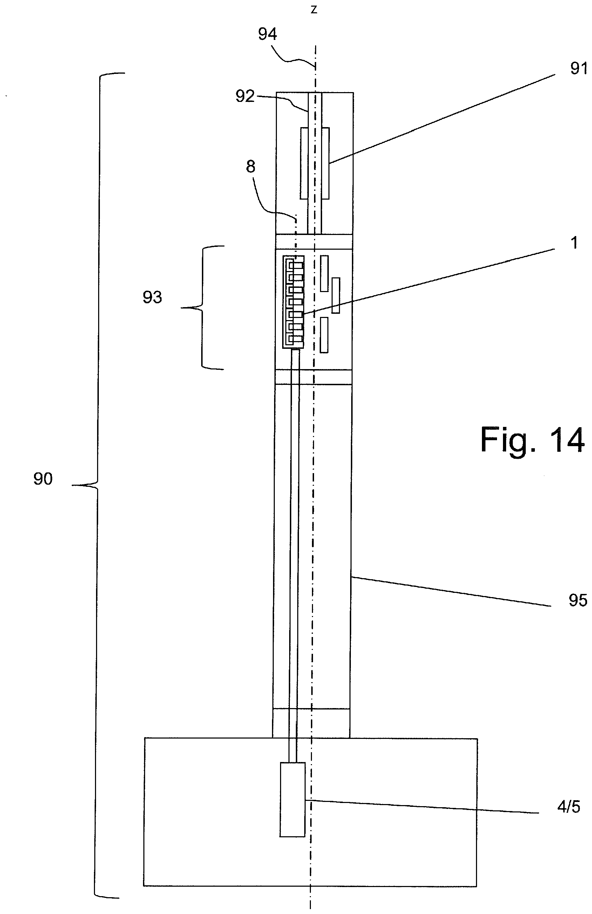

In **Fig. 14** ist schematisch eine Ausführungsform eines erfindungsgemäßen NMR-Probenkopfs 90 dargestellt. Der NMR-Probenkopf 90 verfügt über einen Satz von HF-Resonatorspulen (HF-Spulen) 91. Mit den HF-Resonatorspulen 91 werden HF-Pulse in eine Probe eingestrahlt und/oder HF-Signale aus einer Probe empfangen, wobei die Probe im Inneren der HF-Resonatorspulen angeordnet wird. Dazu kann beispielsweise ein Probenröhrchen (nicht dargestellt) in eine Ausnehmung 92 eingeführt werden; das eingeführte Probenröhrchen durchragt dann den von den HF-Resonatorspulen 91 umschlossenen Raum. Die HF-Resonatorspulen 91 und die Ausnehmung 92 sind entlang einer z-Achse 94 ausgerichtet, die bei Benutzung des NMR-Probenkopfs 90 der Richtung eines statischen Magnetfelds B₀ entspricht.

Die HF-Resonatorspulen 91 sind in nicht näher dargestellter Weise mit einem HF-Netzwerk 93 verbunden. Das HF-Netzwerk 93 umfasst eine erfindungsgemäße Anpassungseinrichtung 1, wie beispielsweise in Fig. 1 dargestellt. Die Anpassungseinrichtung 1 ist über die Bewegungseinrichtung 4, hier eine Rotationseinrichtung 5, betätigbar. Das HF-Netzwerk 93 ist von einem Abschirmrohr 95 umgeben. In der Anpassungseinrichtung 1 sind Drehelemente entlang einer Achse 8 aufgereiht, die parallel zur z-Achse 94 verläuft.

Der NMR-Probenkopf 90 besitzt einen im Wesentlichen zylinderförmigen Aufbau, und ist bei Benutzung typischerweise in die Raumtemperaturbohrung eines Kryostaten, der ein supraleitendes Magnetspulensystem enthält, eingeführt (nicht näher dargestellt).

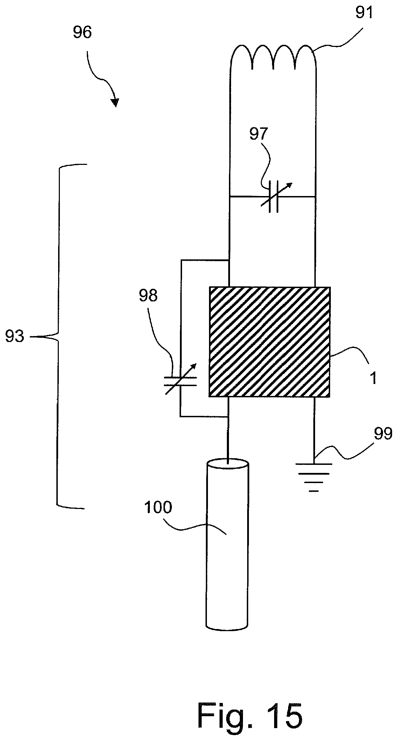

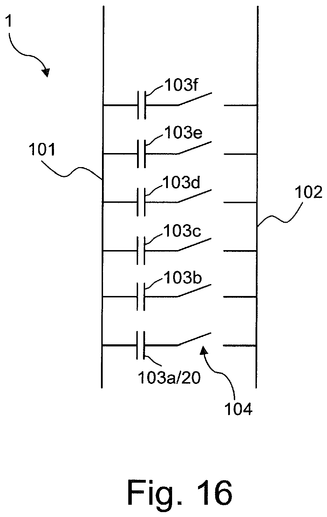

In der **Fig. 15** ist beispielshaft ein HF-Resonanzkreis (Resonatorkreis) 96 gezeigt, der im Rahmen der Erfindung angepasst werden kann. Der HF-Resonanzkreis 96 umfasst wenigstens eine HF-Resonatorspule 91, die an ein HF-Netzwerk 93 angeschlossen ist. Das HF-Netzwerk 93 umfasst hier einen variablen Tuning-Kondensator 97, einen variablen Matching-Kondensator 98 und eine erfindungsgemäße Anpassungseinrichtung 1, mit der hier eine Kapazität zwischen ihren linksseitigen und rechtsseitigen Anschlüssen eingestellt werden kann (siehe dazu auch Fig. 16). Bevorzugt ist die Anpassungseinrichtung 1 mit einem Hauptschalter als Ganzes zu- und abschaltbar (nicht näher dargestellt). Zudem verfügt das HF-Netzwerk 93 über eine Erdung 99 und einen Anschluss für ein Koaxkabel 100, das zu einem Vorverstärker (für die Signalaufnahme) bzw. zu einem Sender (für die Pulsaussendung) verfügt (nicht näher dargestellt).

Die HF-Resonatorspule 91 und das HF-Netzwerk 93 bilden einen Schwingkreis aus, dessen Resonanzfrequenz auf die auszuführende Messaufgabe insbesondere mittels der Anpassungseinrichtung 1 abgestimmt werden kann.

**Fig. 16** illustriert anhand eines Beispiels ein Ersatzschaltbild der Anpassungseinrichtung 1, wie sie im HF-Resonanzkreis 96 von Fig. 15 verwendet werden kann. Die Anpassungseinrichtung 1 verfügt über eine erste Stromschiene (einen ersten Bus) 101 und eine zweite Stromschiene (einen zweiten Bus) 102, zwischen denen verschiedene elektrische Funktionsteile 20, hier Kondensatoren 103a-103f, in Parallelschaltung einzeln zu- oder abgeschaltet werden können.

Die erste Stromschiene 101 kann beispielsweise als eine erste Anschlussanordnung realisiert sein, und die zweite Stromschien 102 als eine zweite Anschlussanordnung. Die jeweiligen Schalter 104 werden durch bewegliche Elemente, etwa Drehelemente, realisiert. Verschiedene Schalterstellungen entsprechen dabei verschiedenen Bewegungsstellungen bzw. Drehstellungen. In den beweglichen Elementen sind die elektrischen Funktionsteile 20 verbaut.

In der gezeigten Ausführungsform sind die Kapazitäten (oder Magnituden der Kapazität) der Kondensatoren 103a-103f gemäß einer binären Reihe aufgebaut, hier beispielhaft mit

| Kondensator | Magnitude der Kapazität |
|---|---|
| 103a | 1 pF |
| 103b | 2 pF |
| 103c | 4 pF |
| 103d | 8 pF |
| 103e | 16 pF |
| 103f | 32 pF |

Mittels der Kondensatoren 103a-103f kann eine Gesamtkapazität zwischen den Stromschienen 101, 102 zwischen 1 pF und 63 pF in Schritten von 1 pF eingestellt werden. Zudem können die beiden Stromschienen 101, 102 voneinander elektrisch isoliert werden, wenn alle Schalter 104 geöffnet werden. Dies entspricht insgesamt 2ⁿ mit n: Anzahl der beweglichen Elemente/Schalter, hier sechs, also insgesamt 64 verschiedenen Kombinationen von Schaltzuständen. Diese können mit einer einzigen Bewegungseinrichtung angefahren werden.

### Bezugszeichenliste

- 1: Anpassungseinrichtung
- 2,3: Lagerschalen
- 4: Bewegungseinrichtung
- 5: Rotationseinrichtung
- 6: bewegliches Element
- 7: Drehelement
- 7a: vorderstes (erstes) Drehelement
- 7b: zweitvorderstes (zweites) Drehelement
- 7c: Drehelement
- 7d: vorletztes Drehelement
- 7e: letztes Drehelement
- 8: Achse
- 9: Ausnehmung (in Lagerschale)
- 10: kreisförmige Randstruktur
- 11: erste Anschlussanordnung
- 12: zweite Anschlussanordnung
- 13: Anschlussfeder
- 14: Anschlussfinger
- 15, 15-15b: elektrische Kontaktelemente
- 16: Durchbruch
- 20, 20a-20b: elektrische Funktionsteile
- 21: erster Funktionsteil-Anschlusspol
- 22: zweiter Funktionsteil-Anschlusspol
- 23, 24: elektrische Kontaktelemente
- 25: Grundkörper
- 26: Oberseite
- 27: Unterseite
- 28: Grundfläche
- 29,30: Vorsprünge
- 31, 32: Vertiefungen
- 33: Seitenflächen
- 61: erste Drehrichtung
- 62: zweite Drehrichtung
- 63: erster Drehanschlag
- 64: zweiter Drehanschlag
- 65: Anschlagbolzen
- 70: Rastmechanismus
- 71: Vertiefung (am Kontaktelement)
- 72: Außenseite
- 73: Vertiefung (an Zwischenstellung)
- 74: Dauerkontaktelement
- 75: Daueranschlussanordnung
- 76: erste Hilfs-Anschlussanordnung
- 77: zweite Hilfs-Anschlussanordnung
- 80: Anschlussfeder (an Daueranschlussanordnung)
- 81: Ein/Aus-Schalter
- 82: Hauptschalter
- 90: NMR-Probenkopf
- 91: HF-Resonatorspule
- 92: Ausnehmung
- 93: HF-Netzwerk
- 94: z-Achse
- 95: Abschirmrohr
- 96: HF-Resonanzkreis
- 97: Tuning-Kondensator
- 98: Matching-Kondensator
- 99: Erdung
- 100: Koaxkabel
- 101: erste Stromschiene
- 102: zweite Stromschiene
- 103a-103f: Kondensatoren
- 104: Schalter
- α: begrenzter Winkelbereich
- β: Winkel (zwischen Drehanschlägen)
- γ: Verstellschrittwinkel (zwischen Raststellungen)

## Patentansprüche

1. Anpassungseinrichtung (1) für einen HF-Resonanzkreis (96) eines NMR-Probenkopfs (90),
**dadurch gekennzeichnet,**
**dass** die Anpassungseinrichtung (1) eine Vielzahl von beweglichen Elementen (6) umfasst, welche aufeinanderfolgend angeordnet sind, wobei jeweils benachbarte bewegliche Elemente (6) ineinander greifen, so dass diese in einem begrenzten Bereich gegeneinander beweglich sind,
**dass** die beweglichen Elemente (6) jeweils wenigstens ein elektrisches Funktionsteil (20; 20a-20b) zur Anpassung des HF-Resonanzkreises (96) und N nach außen gerichtete elektrische Kontaktelemente (15; 15a-15b; 23, 24), mit N eine natürliche Zahl ≥ 1, umfassen, wobei jedes elektrische Funktionsteil (20; 20a-20b) wenigstens zwei Funktionsteil-Anschlusspole (21, 22) aufweist, und wobei die elektrischen Kontaktelemente (15; 15a-15b; 23, 24) jeweils mit einem Funktionsteil-Anschlusspol (21, 22) verbunden sind,
**dass** die Anpassungseinrichtung (1) weiterhin eine erste Anschlussanordnung (11) zum Abfahren zumindest eines Teils der beweglichen Elemente (6) von außen aufweist, um die Kontaktelemente (15; 15a-15b; 23, 24) der beweglichen Elemente (6) abhängig von der Bewegungsstellung der beweglichen Elemente (6) zu kontaktieren, wobei über die erste Anschlussanordnung (11) das jeweilige wenigstens eine elektrische Funktionsteil (20; 20a-20b) der Vielzahl von beweglichen Elementen (6) elektrisch kontaktiert werden kann,
und **dass** die Anpassungseinrichtung (1) weiterhin eine
Bewegungseinrichtung (4) umfasst, mit der ein bewegliches Element (6) der beweglichen Elemente (6) bewegt werden kann.

2. Anpassungseinrichtung (1) nach Anspruch 1, **dadurch gekennzeichnet, dass** die beweglichen Elemente (6) als Drehelemente (7; 7a-7e) ausgebildet sind, welche entlang einer gemeinsamen Achse (8) drehbar gelagert sind und entlang der gemeinsamen Achse (8) aufeinanderfolgend angeordnet sind, und dass die Bewegungseinrichtung (4) weiterhin als Rotationseinrichtung (5) ausgebildet ist, mit der eines der Drehelemente (7; 7a-7e) gedreht werden kann.

3. Anpassungseinrichtung (1) nach Anspruch 2, **dadurch gekennzeichnet, dass** jeweils axial benachbarte Drehelemente (7; 7a-7e) in axialer Richtung ineinander greifen, so dass diese in einem begrenzten Winkelbereich α gegeneinander verdrehbar sind,
und dass die erste Anschlussanordnung (11) ausgebildet ist zum Abfahren der Drehelemente (7; 7a-7e) von radial außen, um die Kontaktelemente (15; 15a-15b; 23, 24) der Drehelemente (7; 7a-7e) abhängig von der Drehstellung der Drehelemente (7; 7a-7e) zu kontaktieren.

4. Anpassungseinrichtung (1) nach Anspruch 3, **dadurch gekennzeichnet, dass** zumindest für einen Teil der Drehelemente (7; 7a-7e), bevorzugt für alle Drehelemente (7; 7a-7e), der begrenzte Winkelbereich α gleich ist, wobei für den begrenzten Winkelbereich α gilt: α=360°/(2*N).

5. Anpassungseinrichtung (1) nach einem der Ansprüche 2 bis 4, **dadurch gekennzeichnet,**
**dass** die Anpassungseinrichtung (1) eine zweite Anschlussanordnung (12) zum Abfahren zumindest eines Teils der Drehelemente (7; 7a-7e) von radial außen aufweist, um die Kontaktelemente (15; 15a-15b; 23, 24) der Drehelemente (7; 7a-7e) abhängig von der Drehstellung der Drehelemente (7; 7a-7e) zu kontaktieren,
und **dass** für die Drehelemente (7; 7a-7e) des besagten Teils jeweils
- die Anzahl der Kontaktelemente (15; 15a-15b; 23, 24) N≥ 2 ist,
- und wenigstens zwei Funktionsteil-Anschlusspole (21, 22) eines Funktionsteils (20; 20a-20b) mit unterschiedlichen Kontaktelementen (15; 15a-15b; 23, 24) verbunden sind.

6. Anpassungseinrichtung (1) nach einem der Ansprüche 2 bis 5, **dadurch gekennzeichnet,**
**dass** zumindest ein Teil der Drehelemente (7; 7a-7e) ein Dauerkontaktelement (74) aufweist, das mit einem ersten Funktionsteil-Anschlusspol (21) wenigstens eines elektrischen Funktionsteils (20; 20a-20b) des Drehelements (7; 7a-7e) verbunden ist,
und **dass** die Anpassungseinrichtung (1) eine Daueranschlussanordnung (75) aufweist, die die Dauerkontaktelemente (74) der Drehelemente (7; 7a-7e) des besagten Teils unabhängig von deren Drehstellung kontaktiert.

7. Anpassungseinrichtung (1) nach einem der vorhergehenden Ansprüche, **dadurch gekennzeichnet, dass** die Bewegungseinrichtung (4) an einem in der Abfolge der beweglichen Elemente (6) vordersten beweglichen Element angreift.

8. Anpassungseinrichtung (1) nach einem der vorhergehenden Ansprüche, **dadurch gekennzeichnet, dass** die Anpassungseinrichtung (1) einen ersten Anschlag aufweist, mit dem die Bewegung eines in der Abfolge der beweglichen Elemente (6) hintersten beweglichen Elements der Anpassungseinrichtung (1) in einer ersten Bewegungsrichtung begrenzt ist.

9. Anpassungseinrichtung (1) nach Anspruch 8, **dadurch gekennzeichnet, dass** die Anpassungseinrichtung (1) weiterhin einen zweiten Anschlag aufweist, mit dem die Bewegung des in der Abfolge der beweglichen Elemente (6) hintersten beweglichen Elements der Anpassungseinrichtung (1) in einer zweiten Bewegungsrichtung, die der ersten Bewegungsrichtung entgegengesetzt ist, begrenzt ist.

10. Anpassungseinrichtung (1) nach einem der vorhergehenden Ansprüche, **dadurch gekennzeichnet, dass** zumindest ein Teil der beweglichen Elemente (6) mit elektrischen Funktionsteilen (20; 20a-20b) mit identischer elektrischer Funktion, aber mit unterschiedlicher Magnitude ausgebildet ist.

11. Anpassungseinrichtung (1) nach Anspruch 10, **dadurch gekennzeichnet, dass** unterschiedliche Magnituden gemäß einer binären Reihe vorgesehen sind, wobei jede der unterschiedlichen Magnituden in einem elektrischen Funktionsteil (20; 20a-20b) eines anderen beweglichen Elements (6) eingerichtet ist.

12. Anpassungseinrichtung (1) nach einem der vorhergehenden Ansprüche, **dadurch gekennzeichnet, dass** die elektrischen Funktionsteile (20; 20a-20b) zumindest eines Teils der beweglichen Elemente (6), insbesondere aller beweglichen Elemente (6), Kondensatoren sind.

13. Anpassungseinrichtung (1) nach einem der vorhergehenden Ansprüche, **dadurch gekennzeichnet, dass** die erste Anschlussanordnung (11) und/oder eine zweite Anschlussanordnung (12) zumindest einen Teil der beweglichen Elemente (6), insbesondere alle beweglichen Elemente (6), elektrisch in Parallelschaltung kontaktiert.

14. Anpassungseinrichtung (1) nach einem der vorhergehenden Ansprüche, **dadurch gekennzeichnet, dass** die erste Anschlussanordnung (11) und/oder eine zweite Anschlussanordnung (12) eine Vielzahl von Anschlussfedern (13) ausbildet, die jeweils auf eine Außenseite (72) eines beweglichen Elements (6) drücken, insbesondere wobei die Anschlussfedern (13) jeweils auf eine radiale Außenseite (72) eines Drehelements (7; 7a-7e) drücken und axial fluchten.

15. Anpassungseinrichtung (1) nach einem der vorhergehenden Ansprüche, **dadurch gekennzeichnet, dass** die Anpassungseinrichtung (1) einen Rastmechanismus (70) umfasst, mit dem die beweglichen Elemente (6) jeweils in verschiedenen Bewegungsstellungen federnd verrastet werden können, insbesondere wobei die beweglichen Elemente (6) als Drehelemente (7; 7a-7e) ausgebildet sind und für jedes Drehelement (7; 7a-7) jeweils 2*N verschiedene verrastbare Drehstellungen, die voneinander um einen Verdrehschrittwinkel γ verschieden sind, vorgesehen sind, mit γ=360°/(2*N).

16. Anpassungseinrichtung (1) nach einem der vorhergehenden Ansprüche, **dadurch gekennzeichnet, dass** die beweglichen Elemente (6) einen Grundkörper (25) aus elektrisch isolierendem Material, insbesondere Kunststoff, aufweisen, wobei die elektrischen Funktionsteile (20; 20a-20b) benachbarter beweglicher Elemente (6) durch eine Schicht des isolierenden Materials wenigstens eines der Grundkörper (25) der benachbarten beweglichen Elemente (6) voneinander separiert sind, insbesondere wobei die beweglichen Elemente (6) als Drehelemente (7; 7a-7e) ausgebildet sind und bei einem jeweiligen Drehelement (7; 7a-7e) der Grundkörper (25) das elektrische Funktionsbauteil (20; 20a-20b) vollständig umschließt und die N elektrischen Kontaktelemente (15; 15a-15b; 23, 24) auf beiden axialen Seiten (26, 27) radial überragt.

17. NMR-Probenkopf (90), der einen HF-Resonanzkreis (96) mit einer HF-Resonatorspule (91) und eine Anpassungseinrichtung (1) nach einem der vorhergehenden Ansprüche aufweist.

18. NMR-Probenkopf (96) nach Anspruch 17, **dadurch gekennzeichnet, dass** der Probenkopf (96) weiterhin einen Hauptschalter (82) umfasst, mit dem die Anpassungseinrichtung (1) insgesamt in den HF-Resonanzkreis (96) geschaltet oder vom HF-Resonanzkreis (96) getrennt werden kann, insbesondere wobei durch den Hauptschalter die Anpassungseinrichtung (1) im HF-Resonanzkreis (96) durch eine oder mehrere Alternativschaltungen ersetzt werden kann.

## Claims

1. Adjustment device (1) for an RF resonant circuit (96) of an NMR probe head (90), **characterized in that** the adjustment device (1) comprises a plurality of movable elements (6) which are arranged in succession, adjacent movable elements (6) mutually engaging in each case so as to be movable relative to one another in a limited range,
**in that** the movable elements (6) each comprise at least one electrical functional part (20; 20a-20b) for adjusting the RF resonant circuit (96) and N outwardly oriented electrical contact elements (15; 15a-15b; 23, 24), where N is a natural number ≥ 1, each electrical functional part (20; 20a-20b) comprising at least two functional part terminals (21, 22), and the electrical contact elements (15; 15a-15b; 23, 24) each being connected to a functional part terminal (21, 22),
**in that** the adjustment device (1) further comprises a first connection assembly (11) for slidingly contacting at least a portion of the movable elements (6) from the outside in order to contact the contact elements (15; 15a-15b; 23, 24) of the movable elements (6) depending on the movement position of the movable elements (6), wherein the respective at least one electrical functional part (20; 20a-20b) of the plurality of movable elements (6) can be electrically contacted via the first connection assembly (11),
and **in that** the adjustment device (1) further comprises a movement device (4), by means of which one movable element (6) of the movable elements (6) can be moved.

2. Adjustment device (1) according to claim 1, **characterized in that** the movable elements (6) are formed as rotary elements (7; 7a-7e) that are rotatably mounted along a common axis (8) and are arranged in succession along the common axis (8), and **in that** the movement device (4) is further formed as a rotation device (5), by means of which one of the rotary elements (7; 7a-7e) can be rotated.

3. Adjustment device (1) according to claim 2, **characterized in that** the rotary elements (7; 7a-7e) that are axially adjacent in each case mutually engage in the axial direction, so as to be rotatable relative to one another in a limited angle range α,
and **in that** the first connection assembly (11) is designed for slidingly contacting the rotary elements (7; 7a-7e) from radially outside in order to contact the contact elements (15; 15a-15b; 23, 24) of the rotary elements (7; 7a-7e), depending on the rotational position of the rotary elements (7; 7a-7e).

4. Adjustment device (1) according to claim 3, **characterized in that** the limited angle range α is the same for at least a portion of the rotary elements (7; 7a-7e), preferably for all of the rotary elements (7; 7a-7e), α=360°/(2*N) being applicable for the limited angle range a.

5. Adjustment device (1) according to any of claims 2 to 4, **characterized in that**
the adjustment device (1) comprises a second connection assembly (12) for slidingly contacting at least a portion of the rotary elements (7; 7a-7e) from radially outside in order to contact the contact elements (15; 15a-15b; 23, 24) of the rotary elements (7; 7a-7e), depending on the rotational position of the rotary elements (7; 7a-7e),
and **in that**, for the rotary elements (7; 7a-7e) of said portion, in each case
- the number of contact elements (15; 15a-15b; 23, 24) is N ≥ 2,
- and at least two functional part terminals (21, 22) of a functional part (20; 20a-20b) are connected to different contact elements (15; 15a-15b; 23, 24).

6. Adjustment device (1) according to any of claims 2 to 5, **characterized in that** at least a portion of the rotary elements (7; 7a-7e) comprises a permanent contact element (74) that is connected to a first functional part terminal (21) of at least one electrical functional part (20; 20a-20b) of the rotary element (7; 7a-7e),
and **in that** the adjustment device (1) comprises a permanent connection assembly (75) that contacts the permanent contact elements (74) of the rotary elements (7; 7a-7e) of said portion, irrespective of the rotational position of said contact elements.

7. Adjustment device (1) according to any of the preceding claims, **characterized in that** the movement device (4) acts on the frontmost movable element in the sequence of the movable elements (6).

8. Adjustment device (1) according to any of the preceding claims, **characterized in that** the adjustment device (1) comprises a first stop that limits the movement, in a first movement direction, of the rearmost movable element of the adjustment device (1) in the sequence of the movable elements (6).

9. Adjustment device (1) according to claim 8, **characterized in that** the adjustment device (1) further comprises a second stop that limits the movement, in a second movement direction that is counter to the first movement direction, of the rearmost movable element of the adjustment device (1) in the sequence of the movable elements (6).

10. Adjustment device (1) according to any of the preceding claims, **characterized in that** at least one portion of the movable elements (6) is designed having electrical functional parts (20; 20a-20b) that have an identical electrical function but different magnitudes.

11. Adjustment device (1) according to claim 10, **characterized in that** different magnitudes are provided according to a binary series, each of the different magnitudes being established in an electrical functional part (20; 20a-20b) of a different movable element (6).

12. Adjustment device (1) according to any of the preceding claims, **characterized in that** the electrical functional parts (20; 20a-20b) of at least one portion of the movable elements (6), in particular of all the movable elements (6), are capacitors.

13. Adjustment device (1) according to any of the preceding claims, **characterized in that** the first connection assembly (11) and/or a second connection assembly (12) electrically contacts at least a portion of the movable elements (6), in particular all the movable elements (6), in parallel.

14. Adjustment device (1) according to any of the preceding claims, **characterized in that** the first connection assembly (11) and/or a second connection assembly (12) forms a plurality of connection springs (13) that each press against an outer face (72) of a movable element (6), in particular the connection springs (13) each pressing against a radial outer face (72) of a rotary element (7; 7a-7e) and being axially aligned.

15. Adjustment device (1) according to any of the preceding claims, **characterized in that** the adjustment device (1) comprises a latching mechanism (70) by means of which the movable elements (6) can be resiliently latched in different movement positions in each case,
in particular the movable elements (6) being formed as rotary elements (7; 7a-7e) and in each case 2*N different latchable rotational positions being provided for each rotary element (7; 7a-7e), which positions differ from one another by a rotation step angle γ, where γ=360°/(2*N).

16. Adjustment device (1) according to any of the preceding claims, **characterized in that** the movable elements (6) comprise a main body (25) made of an electrically insulating material, in particular plastics material, the electrical functional parts (20; 20a-20b) of adjacent movable elements (6) being separated from one another by a layer of the insulating material of at least one of the main bodies (25) of the adjacent movable elements (6),
in particular the movable elements (6) being formed as rotary elements (7; 7a-7e) and, in the case of each rotary element (7; 7a-7e), the main body (25) completely surrounding the electrical functional component (20; 20a-20b), and the main body (25) radially protruding beyond the N electrical contact elements (15; 15a-15b; 23, 24) on the two axial sides (26, 27).

17. NMR probe head (90) comprising an RF resonant circuit (96) having an RF resonator coil (91) and an adjustment device (1) according to any of the preceding claims.

18. NMR probe head (96) according to claim 17, **characterized in that** the probe head (96) further comprises a master switch (82), by means of which the adjustment device (1) as a whole can be connected into the RF resonant circuit (96) or separated from the RF resonant circuit (96), in particular the master switch making it possible for the adjustment device (1) to be replaced in the RF resonant circuit (96) by one or more alternative circuits.

## Revendications

1. Dispositif de réglage (1) pour un circuit résonant HF (96) d'une tête d'échantillon de RMN (90), **caractérisé**
**en ce que** le dispositif de réglage (1) comprend une pluralité d'éléments mobiles (6), qui sont agencés les uns à la suite des autres, des éléments mobiles voisins (6) s'engageant à chaque fois les uns dans les autres, de telle sorte que ceux-ci sont mobiles les uns par rapport aux autres dans une plage limitée,
**en ce que** les éléments mobiles (6) comprennent chacun au moins une partie fonctionnelle électrique (20 ; 20a-20b) pour le réglage du circuit résonant HF (96) et N éléments de contact électriques dirigés vers l'extérieur (15 ; 15a-15b ; 23, 24), N étant un nombre naturel ≥ 1 , chaque partie fonctionnelle électrique (20 ; 20a-20b) comprenant au moins deux pôles de raccordement de partie fonctionnelle (21, 22), et les éléments de contact électriques (15 ; 15a-15b ; 23, 24) étant chacun reliés à un pôle de raccordement de partie fonctionnelle (21, 22),
**en ce que** le dispositif de réglage (1) comprend en outre un premier agencement de raccordement (11) pour le transport d'au moins une partie des éléments mobiles (6) à partir de l'extérieur, afin de venir en contact avec les éléments de contact (15 ; 15a-15b ; 23, 24) des éléments mobiles (6) en fonction de la position de déplacement des éléments mobiles (6), l'au moins une partie fonctionnelle électrique respective (20 ; 20a-20b) de la pluralité d'éléments mobiles (6) pouvant être contactée électriquement par l'intermédiaire du premier agencement de raccordement (11),
et **en ce que** le dispositif de réglage (1) comprend en outre un dispositif de déplacement (4), avec lequel un élément mobile (6) parmi les éléments mobiles (6) peut être déplacé.

2. Dispositif de réglage (1) selon la revendication 1, **caractérisé en ce que** les éléments mobiles (6) sont configurés en tant qu'éléments rotatifs (7 ; 7a-7e), qui sont montés de manière rotative le long d'un axe commun (8) et qui sont agencés les uns à la suite des autres le long de l'axe commun (8), et **en ce que** le dispositif de déplacement (4) est en outre configuré en tant que dispositif de rotation (5), avec lequel un des éléments rotatifs (7 ; 7a-7e) peut être tourné.

3. Dispositif de réglage (1) selon la revendication 2, **caractérisé en ce que** des éléments rotatifs axialement voisins (7 ; 7a-7e) s'engagent à chaque fois les uns dans les autres en direction axiale, de telle sorte que ceux-ci peuvent être amenés à tourner les uns par rapport aux autres dans une plage angulaire limitée α,
et **en ce que** le premier agencement de raccordement (11) est configuré pour le transport des éléments rotatifs (7 ; 7a-7e) radialement à partir de l'extérieur, afin de venir en contact avec les éléments de contact (15 ; 15a-15b ; 23, 24) des éléments rotatifs (7 ; 7a-7e) en fonction de la position de rotation des éléments rotatifs (7 ; 7a-7e).

4. Dispositif de réglage (1) selon la revendication 3, **caractérisé en ce qu'**au moins pour une partie des éléments rotatifs (7 ; 7a-7e), de préférence pour tous les éléments rotatifs (7 ; 7a-7e), la plage angulaire limitée α est identique, avec pour la plage angulaire limitée α : α = 360°/(2*N).

5. Dispositif de réglage (1) selon l'une quelconque des revendications 2 à 4, **caractérisé**
**en ce que** le dispositif de réglage (1) comprend un deuxième agencement de raccordement (12) pour le transport d'au moins une partie des éléments rotatifs (7 ; 7a-7e) radialement à partir de l'extérieur, afin de venir en contact avec les éléments de contact (15 ; 15a-15b ; 23, 24) des éléments rotatifs (7 ; 7a-7e) en fonction de la position de rotation des éléments rotatifs (7 ; 7a-7e),
et **en ce que** pour les éléments rotatifs (7 ; 7a-7e) de ladite partie, à chaque fois
- le nombre d'éléments de contact (15 ; 15a-15b ; 23, 24) N est ≥ 2,
- et au moins deux pôles de raccordement de partie fonctionnelle (21, 22) d'une partie fonctionnelle (20 ; 20a-20b) sont reliés à différents éléments de contact (15 ; 15a-15b ; 23, 24).

6. Dispositif de réglage (1) selon l'une quelconque des revendications 2 à 5, **caractérisé**
**en ce qu'**au moins une partie des éléments rotatifs (7 ; 7a-7e) comprend un élément de contact permanent (74), qui est relié à un premier pôle de raccordement de partie fonctionnelle (21) d'au moins une partie fonctionnelle électrique (20 ; 20a-20b) de l'élément rotatif (7 ; 7a-7e),
et **en ce que** le dispositif de réglage (1) comprend un agencement de raccordement permanent (75), qui vient en contact avec les éléments de contact permanent (74) des éléments rotatifs (7 ; 7a-7e) de ladite partie indépendamment de leur position de rotation.

7. Dispositif de réglage (1) selon l'une quelconque des revendications précédentes, **caractérisé en ce que** le dispositif de déplacement (4) vient en prise avec un élément mobile le plus en avant dans la succession des éléments mobiles (6).

8. Dispositif de réglage (1) selon l'une quelconque des revendications précédentes, **caractérisé en ce que** le dispositif de réglage (1) comprend une première butée, avec laquelle le déplacement d'un élément mobile le plus en arrière dans la succession des éléments mobiles (6) du dispositif de réglage (1) est limité dans une première direction de déplacement.

9. Dispositif de réglage (1) selon la revendication 8, **caractérisé en ce que** le dispositif de réglage (1) comprend en outre une deuxième butée, avec laquelle le déplacement de l'élément mobile le plus en arrière dans la succession des éléments mobiles (6) du dispositif de réglage (1) est limité dans une deuxième direction de déplacement, qui est opposée à la première direction de déplacement.

10. Dispositif de réglage (1) selon l'une quelconque des revendications précédentes, **caractérisé en ce qu'**au moins une partie des éléments mobiles (6) munis de parties fonctionnelles électriques (20 ; 20a-20b) sont configurés avec une fonction électrique identique, mais toutefois avec une magnitude différente.

11. Dispositif de réglage (1) selon la revendication 10, **caractérisé en ce que** des magnitudes différentes sont prévues selon une série binaire, chacune des magnitudes différentes étant mise en place dans une partie fonctionnelle électrique (20 ; 20a-20b) d'un autre élément mobile (6).

12. Dispositif de réglage (1) selon l'une quelconque des revendications précédentes, **caractérisé en ce que** les parties fonctionnelles électriques (20 ; 20a-20b) d'au moins une partie des éléments mobiles (6), notamment de tous les éléments mobiles (6), sont des condensateurs.

13. Dispositif de réglage (1) selon l'une quelconque des revendications précédentes, **caractérisé en ce que** le premier agencement de raccordement (11) et/ou un deuxième agencement de raccordement (12) viennent en contact électriquement en connexion parallèle avec au moins une partie des éléments mobiles (6), notamment tous les éléments mobiles (6).

14. Dispositif de réglage (1) selon l'une quelconque des revendications précédentes, **caractérisé en ce que** le premier agencement de raccordement (11) et/ou un deuxième agencement de raccordement (12) forment une pluralité de ressorts de raccordement (13), qui appuient chacun sur un côté extérieur (72) d'un élément mobile (6),
les ressorts de raccordement (13) appuyant notamment chacun sur un côté extérieur radial (72) d'un élément rotatif (7 ; 7a-7e) et étant alignés axialement.

15. Dispositif de réglage (1) selon l'une quelconque des revendications précédentes, **caractérisé en ce que** le dispositif de réglage (1) comprend un mécanisme d'encliquetage (70), avec lequel les éléments mobiles (6) peuvent chacun être encliquetés élastiquement dans différentes positions de déplacement,
les éléments mobiles (6) étant notamment configurés en tant qu'éléments rotatifs (7 ; 7a-7e) et, pour chaque élément rotatif (7 ; 7a-7), à chaque fois 2*N positions de rotation encliquetables différentes, qui diffèrent les unes des autres d'un angle de pas de rotation γ, étant prévues, avec γ= 360°/(2*N).

16. Dispositif de réglage (1) selon l'une quelconque des revendications précédentes, **caractérisé en ce que** les éléments mobiles (6) comprennent un corps de base (25) en matériau électriquement isolant, notamment en matière plastique, les parties fonctionnelles électriques (20 ; 20a-20b) d'éléments mobiles voisins (6) étant séparées les unes des autres par une couche du matériau isolant d'au moins un des corps de base (25) des éléments mobiles voisins (6),
les éléments mobiles (6) étant notamment configurés en tant qu'éléments rotatifs (7 ; 7a-7e) et, pour un élément rotatif respectif (7 ; 7a-7e), le corps de base (25) entourant complètement le composant fonctionnel électrique (20 ; 20a-20b) et les N éléments de contact électriques (15 ; 15a-15b ; 23, 24) dépassant radialement des deux côtés axiaux (26, 27).

17. Tête d'échantillon de RMN (90), qui comprend un circuit résonant HF (96) muni d'une bobine de résonateur HF (91) et un dispositif de réglage (1) selon l'une quelconque des revendications précédentes.

18. Tête d'échantillon de RMN (96) selon la revendication 17, **caractérisée en ce que** la tête d'échantillon (96) comprend en outre un commutateur principal (82), avec lequel le dispositif de réglage (1) peut être entièrement connecté dans le circuit résonant HF (96) ou séparé du circuit résonant HF (96), le dispositif de réglage (1) pouvant notamment être remplacé par un ou plusieurs montages alternatifs dans le circuit résonant HF (96) par le commutateur principal.
